(19) Europäisches Patentamt
European Patent Office
Office européen des brevets

(11) **EP 3 005 567 B1**

(12) **FASCICULE DE BREVET EUROPEEN**

(45) Date de publication et mention
de la délivrance du brevet:
**19.07.2017 Bulletin 2017/29**

(51) Int Cl.:
***H03L 7/16*** *(2006.01)*      ***H04B 1/717*** *(2011.01)*

(21) Numéro de dépôt: **14729247.8**

(22) Date de dépôt: **26.05.2014**

(86) Numéro de dépôt international:
**PCT/EP2014/060793**

(87) Numéro de publication internationale:
**WO 2014/191339 (04.12.2014 Gazette 2014/49)**

(54) **DISPOSITIF ET PROCÉDÉ DE SYNTHÈSE DE FRÉQUENCES**

FREQUENZSYNTHESEVORRICHTUNG UND -VERFAHREN

FREQUENCY SYNTHESIS DEVICE AND METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.05.2013 FR 1354752**

(43) Date de publication de la demande:
**13.04.2016 Bulletin 2016/15**

(73) Titulaire: **Commissariat à l'Énergie Atomique
et aux Énergies Alternatives
75015 Paris (FR)**

(72) Inventeurs:
• **SILIGARIS, Alexandre
  F-38100 Grenoble (FR)**
• **GONZALEZ JIMENEZ, José-Luis
  F-38340 Voreppe (FR)**

(74) Mandataire: **Brevalex
  95, rue d'Amsterdam
  75378 Paris Cedex 8 (FR)**

(56) Documents cités:
**WO-A1-2008/069444**

• **RUI XU ET AL: "Power-Efficient Switching-Based
  CMOS UWB Transmitters for UWB
  Communications and Radar Systems", IEEE
  TRANSACTIONS ON MICROWAVE THEORY AND
  TECHNIQUES, IEEE SERVICE CENTER,
  PISCATAWAY, NJ, US, vol. 54, no. 8, 1 août 2006
  (2006-08-01), pages 3271-3277, XP001545203,
  ISSN: 0018-9480, DOI:
  10.1109/TMTT.2006.877830**

**Description**

**DOMAINE TECHNIQUE**

L'invention concerne le domaine des dispositifs émetteurs - récepteurs, et notamment celui des dispositifs émetteurs - récepteurs sans fil intégrés faisant appel à des signaux stables en fréquence pour réaliser une ou plusieurs transpositions de fréquences dans la partie émission et/ou réception de ces dispositifs. L'invention concerne notamment un dispositif et un procédé de synthèse de fréquences permettant de fournir des signaux stables en fréquence à partir d'un signal stable de fréquence inférieure. L'invention concerne également un dispositif d'émission et/ou de réception de signaux, fonctionnant par exemple dans le domaine des radiofréquences (RF), comportant un tel dispositif de synthèse de fréquences destiné à fournir en sortie des signaux périodiques stables utilisés lors d'une émission - réception de signaux.

**ÉTAT DE LA TECHNIQUE ANTÉRIEURE**

Un dispositif de synthèse de fréquence permet de fournir un signal stable en fréquence destiné à être utilisé par exemple dans un système de communication RF. Ainsi, lors d'une émission de signaux, un signal contenant l'information à envoyer peut être modulé avec le signal stable en fréquence servant de signal porteur pour véhiculer cette information. La synthèse de fréquence réalisée définit dans ce cas la valeur de la fréquence porteuse d'émission. Lors d'une réception de signaux, la synthèse de fréquence permet de fournir ce signal stable en fréquence pour démoduler l'information reçue. Le signal stable en fréquence obtenu peut également servir à réaliser une transposition de fréquences entre la bande de base et des fréquences intermédiaires, ou entre les fréquences intermédiaires et les fréquences porteuses d'émission et de réception.

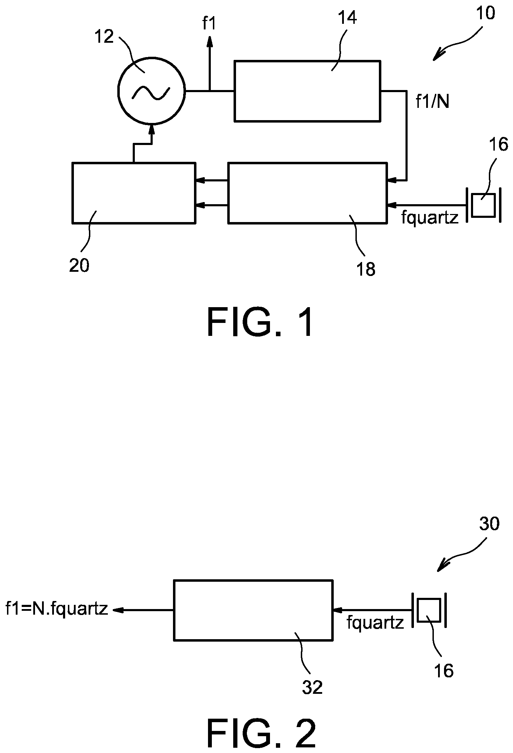

Un premier exemple de réalisation d'un dispositif de synthèse de fréquence 10, utilisé par exemple dans un système d'émission / réception à fréquence porteuse, est représenté sur la figure 1.

Le dispositif 10 comporte un oscillateur 12 commandé en tension (VCO pour « Voltage-Controlled Oscillator »), fournissant en sortie un signal sinusoïdal dont la fréquence d'oscillation est contrôlée par une tension appliquée en entrée de l'oscillateur 12. L'oscillateur 12 est réalisé tel qu'il puisse fournir en sortie un signal oscillant dans la bande des fréquences utilisées par le système de communication dont fait partie le dispositif 10. On considère que l'oscillateur 12 fournit en sortie un signal sinusoïdal de fréquence $f_1$.

Le signal de sortie fourni par l'oscillateur 12 seul est instable dans les bandes de fréquences RF et les micro-ondes, dérive dans le temps et présente une impureté spectrale (bruit de phase) élevée. Il est donc nécessaire de le stabiliser en fréquence en verrouillant (c'est-à-dire en fixant, ou synchronisant) sa phase sur celle d'un signal très stable en fréquence fourni par exemple par un résonateur de très haute qualité, tel qu'un résonateur à quartz, qui fonctionne toutefois à plus basse fréquence (généralement dans le domaine des MHz).

Afin de verrouiller la phase du signal délivré par l'oscillateur 12 et stabiliser ainsi la fréquence d'oscillation $f_1$ de ce signal, l'oscillateur 12 est asservi au sein d'une boucle à verrouillage de phase (PLL pour « Phase-Locked Loop »). Cette PLL comporte plusieurs diviseurs de fréquence reliés en série les uns aux autres (représentés sous la forme d'un seul élément référencé 14 sur la figure 1) et aptes à diviser ensemble la fréquence $f_1$ du signal délivré par l'oscillateur 12 par un nombre N entier ou fractionnaire. On obtient en sortie des diviseurs de fréquence 14 un signal périodique de fréquence $f_1/N$ qui est ensuite comparé à un signal périodique de référence très stable, tel qu'un signal de fréquence $f_{quartz}$ fourni par un résonateur 16 à quartz. Les diviseurs de fréquence 14 sont réalisés tels que le facteur N obtenu permette que la fréquence $f_1/N$ soit proche de la fréquence $f_{quartz}$. La comparaison entre ces deux signaux est réalisée par un comparateur de phases 18 (PFD pour « Phase Frequency Detector ») générant en sortie des signaux proportionnels à la différence de phases mesurée entre ces deux signaux et dont la valeur est positive ou négative selon le signe de la différence $f_1/N$ - $f_{quartz}$. Ce signal de sortie est envoyé en entrée d'un circuit de pompe de charge et d'un filtre 20 délivrant en sortie un signal appliqué sur l'entrée de commande de l'oscillateur 12 permettant d'ajuster sa fréquence d'oscillation de sorte à ce que $f_1/N$ = $f_{quartz}$ une fois la boucle stabilisée.

Avec un tel dispositif de synthèse de fréquence 10, la stabilité en fréquence du signal de fréquence $f_1$ délivré par l'oscillateur 12, sa dérive dans le temps et sa pureté spectrale dépendent essentiellement des caractéristiques du signal de référence de fréquence $f_{quartz}$ fourni par le résonateur 16 ainsi que du rang de division N des diviseurs de fréquence 14. De plus, les fréquences synthétisables par le dispositif 10 dépendent également de la plage de fréquence d'oscillation de l'oscillateur 12 qui est telle que :

$$f_{osc\,\min} < N \cdot f_{quartz} < f_{osc\,\max}$$

$f_{oscmin}$ et $f_{oscmax}$ étant respectivement les fréquences d'oscillation minimum et maximum de l'oscillateur 12.

L'oscillateur 12 est par exemple réalisé sous la forme de paires croisées différentielles (résonateur couplé avec une résistance négative). Les diviseurs de fréquence 14 utilisent différentes architectures selon qu'ils soient positionnés en début de chaîne (proche de la fréquence $f_1$, c'est-à-dire du côté de l'oscillateur 12) ou en fin de chaîne, à plus basse fréquence (proche de la fréquence $f_{quartz}$, c'est-à-dire du côté du comparateur de phases 18). Aux fréquences élevées, les diviseurs de fréquence utilisent des circuits de type CML (« Current Mode Logic ») ou ILFD (« Injection Locked Frequency Divider »). Les diviseurs de fréquence fonctionnant à plus basses fréquences utilisent des architectures purement numériques de type compteur. Les circuits formant les diviseurs de fréquence 14 peuvent être programmables afin que la valeur de la fréquence synthétisée par le dispositif 10 soit programmable ($f_1$ est dans ce cas un multiple de $f_{quartz}$) via le choix de la valeur de N (la valeur de $f_{quartz}$ est fonction de la nature du résonateur 16 et n'est donc pas programmable).

Ce type de dispositif de synthèse de fréquence 10 présente l'inconvénient majeur d'utiliser une longue chaîne de diviseurs de fréquence 14 compte tenu de la valeur importante de N lorsque la différence entre $f_{quartz}$ et $f_1$ est grande. Les premiers diviseurs de fréquence (ceux du côté de l'oscillateur 12) fonctionnant à hautes fréquences présentent une consommation électrique statique élevée. De plus, lorsque les premiers diviseurs de fréquence emploient une architecture de type ILFD, ils utilisent dans ce cas des éléments résonants (inductances ou lignes de transmission) occupant une surface de circuit importante. D'autre part, la PLL utilise une rétroaction qui agit sur la fréquence d'oscillation de l'oscillateur 12. Or, cette rétroaction peut mener la PLL à des instabilités (non verrouillage de la fréquence $f_1$) du fait que cette boucle fonctionne à haute fréquence.

Un deuxième exemple de réalisation d'un dispositif de synthèse de fréquence 30, utilisé dans un système d'émission / réception à fréquence porteuse élevée (domaine RF), est représenté sur la figure 2.

Par rapport au dispositif 10 précédemment décrit, ce deuxième dispositif de synthèse de fréquence 30 utilise une approche inverse consistant à multiplier la fréquence de référence $f_{quartz}$ jusqu'à obtention de la fréquence requise $f_1$. Comme représenté sur la figure 2, un tel dispositif 30 comporte un résonateur 16, par exemple similaire à celui du dispositif 10 précédemment décrit, délivrant en sortie le signal stable de référence de fréquence $f_{quartz}$. Ce signal est appliqué en entrée d'une chaîne de circuits multiplicateur de fréquence 32 de rang N (représentée sous la forme d'un seul élément sur la figure 2) apte à délivrer en sortie le signal de fréquence $f_1 = N.f_{quartz}$.

Le dispositif 30 ne comporte pas d'oscillateur ni de boucle à verrouillage de phase. Les premiers circuits multiplicateur de fréquences 32 (ceux se trouvant du côté du résonateur 16) fonctionnent à basses fréquences et utilisent des architectures numériques standards. Par contre, les circuits multiplicateur de fréquence 32 se trouvant en fin de chaîne fonctionnent à hautes fréquences et utilisent des architectures à verrouillage sous-harmonique, ou font appel à des techniques dites « push-push », à distorsion, à amplification harmonique ou autres. La stabilité et la pureté du signal (bruit de phase) de fréquence $f_1$ obtenu en sortie du dispositif de synthèse de fréquence 30 dépendent essentiellement des caractéristiques du signal stable de référence fourni par le résonateur 16 et du rang de multiplication N.

Lorsque le rang de multiplication N est élevé (ce qui est le cas pour un dispositif de synthèse de fréquence faisant partie d'un système de communication RF), il est nécessaire d'utiliser un nombre important de circuits multiplicateur de fréquence pour réaliser la chaîne 32, se traduisant par une consommation et une surface de circuit occupée importantes. De plus, il n'existe pas de circuit multiplicateur de fréquence programmable, ce qui rend le rang N fixe et ne permet pas au dispositif 30 de synthétiser des fréquences de manière programmable.

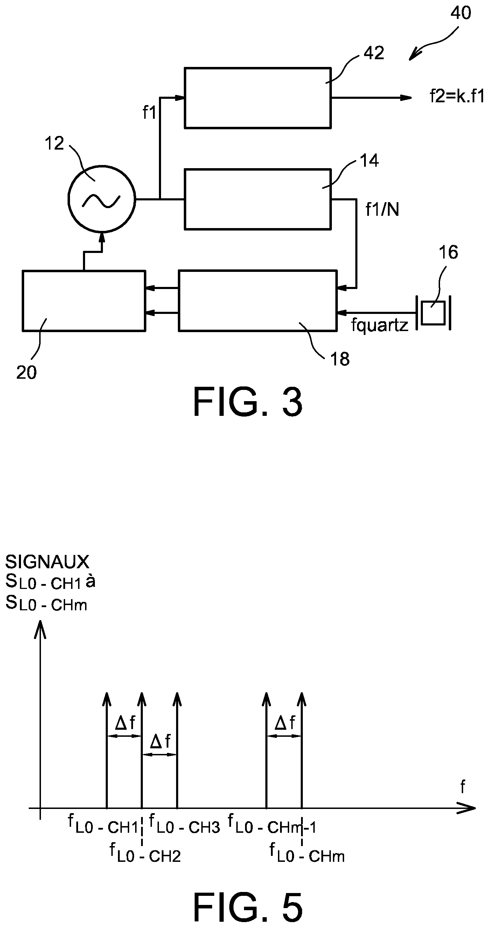

Un troisième exemple de réalisation d'un dispositif de synthèse de fréquence 40, utilisé par exemple dans un système d'émission / réception à fréquence porteuse élevée (RF), est représenté sur la figure 3.

L'architecture de ce dispositif 40 correspond à une combinaison des architectures des dispositifs de synthèse de fréquence 10 et 30 précédemment décrits. Une première synthèse de fréquence est effectuée à la fréquence $f_1$ en utilisant une architecture similaire à celle du dispositif 10 (en faisant appel à des éléments analogues aux éléments 12, 14, 16, 18, 20 du dispositif 10). Le signal de fréquence $f_1$ est ensuite multiplié par une chaîne de circuits multiplicateur de fréquence 42 de rang K afin d'obtenir en sortie un signal de fréquence $f_2 = K.f_1 = K.N.f_{quartz}$.

Un tel dispositif 40 a pour avantage de pouvoir synthétiser des fréquences programmables (via la programmation du paramètre N) et d'augmenter la valeur de la fréquence pouvant être obtenue en sortie. Les fréquences synthétisables sont telles que :

$$f_{osc\min} < N \cdot K \cdot f_{quartz} < f_{osc\max}$$

Bien que le dispositif de synthèse de fréquence 40 résolve une partie des inconvénients des dispositifs de synthèse de fréquence 10 et 30, tous ces dispositifs de synthèse de fréquence ont pour inconvénient de faire appel à des chaînes complètes de diviseurs et/ou multiplicateurs de fréquence de rangs élevés (N et K pouvant être de l'ordre de plusieurs centaines ou plusieurs milliers), en raison des grandes différences entre les valeurs des fréquences porteuses destinées à être obtenues en sortie des dispositifs et les fréquences relativement basses pouvant être fournies par des résonateurs stables tels que des résonateurs à quartz. Or, ces chaînes complètes de circuits diviseurs ou multiplicateurs de fréquence présentent une importante consommation électrique et occupent une surface de circuit également importante.

La génération de plusieurs signaux stables en fréquence est également nécessaire dans le cas d'une émission - réception de signaux dans une large bande de fréquences RF, par exemple de plusieurs GHz, qui nécessite de réaliser une division de cette large bande en plusieurs sous-bandes de fréquences différentes afin de traiter en parallèle et de façon simultanée en bande de base les signaux émis et reçus en les divisant en plusieurs canaux. Dans ce cas, il est possible de faire appel à plusieurs dispositifs similaires à ceux précédemment décrits. Plusieurs générateurs de fréquence, ou dispositifs de synthèse de fréquence, comprenant chacun un oscillateur local sont généralement utilisés dans ce cas pour réaliser le multiplexage et le démultiplexage dans le domaine fréquentiel de ces sous-bandes de fréquences.

Le document « A Multigigabit Millimeter-Wave Communication System With Improved Spectral Efficiency » de V. Dyadyuk et al., Microwave Theory and Techniques, IEEE Transactions on, vol.55, n°12, pages 2813-2821, Décembre 2007, décrit un tel système émetteur - récepteur dans lequel des données numériques sont réparties dans N canaux pour pouvoir être traitées. Du côté émetteur, des signaux analogiques de fréquences intermédiaires issus de chaque canal numérique et obtenus grâce à N convertisseurs numérique - analogique sont multiplexés dans le domaine fréquentiel souhaité, nécessitant pour cela N oscillateurs locaux utilisés avec N mélangeurs. Le signal de fréquence intermédiaire obtenu est ensuite transposé à la fréquence d'émission par un premier convertisseur sous-harmonique amplifié puis transmis par une antenne. Du côté récepteur, le signal reçu est transposé vers les fréquences intermédiaires par un autre convertisseur sous-harmonique amplifié, puis démultiplexé dans le domaine fréquentiel des N sous-bandes de fréquences des N canaux via l'utilisation N oscillateurs locaux et de N mélangeurs, les signaux obtenus étant échantillonnés ensuite par N convertisseurs analogique - numérique et enfin décodés par un FPGA dans des canaux numériques et multiplexés en un seul flux numérique.

Un tel système a pour principal inconvénient de faire appel à de nombreux oscillateurs locaux du côté émission et du côté réception pour pouvoir réaliser les transpositions de fréquences, ce qui pose d'évidents problèmes de coûts, de complexité et de surface nécessaire à leur réalisation.

Le document US 2010/0142598 A1 décrit un autre type de système émetteur - récepteur faisant appel également à plusieurs canaux. Là encore, de multiples oscillateurs locaux sont nécessaires pour réaliser le multiplexage et le démultiplexage dans le domaine fréquentiel des signaux dans les différents canaux.

La publication WO 2008/069444 A1 divulgue un générateur d'impulsions à puissance ultra-basse pour un système radio d'impulsion à bande multiple contenant une unité de réglage pour faire varier la fréquence du signal sinusoïdal produit à la sortie du générateur.

## EXPOSÉ DE L'INVENTION

Un but de la présente invention est de proposer un nouveau type de dispositif de synthèse de fréquences ne présentant pas les inconvénients des dispositifs de synthèse de fréquences de l'art antérieur exposés précédemment, et permettant de générer plusieurs signaux périodiques stables en fréquence sans faire appel à autant d'oscillateurs locaux que de signaux destinés à être générés.

Pour cela, il est proposé un dispositif de synthèse de fréquences, comportant au moins :

- des premiers moyens aptes à générer un signal périodique de fréquence $f_1$,
- des deuxièmes moyens aptes à générer au moins un signal périodique impulsionnel dont une fréquence centrale $f_G$ est égale à $N.f_1$, avec N nombre entier supérieur à 1,
- des troisièmes moyens couplés aux premiers et deuxièmes moyens, aptes à recevoir en entrée le signal périodique de fréquence $f_1$ et à commander la génération du signal périodique impulsionnel par les deuxièmes moyens seulement sur une partie de chaque période du signal périodique de fréquence $f_1$,
- des quatrièmes moyens aptes à générer, à partir du signal périodique impulsionnel délivré par les deuxièmes moyens, des signaux périodiques $S_{LO\_CH1}$ à $S_{LO\_CHm}$, par exemple sinusoïdaux, de fréquence $f_{LO\_CH1}$ à $f_{LO\_CHm}$ correspondant à des multiples entiers de $f_1$.

La présente invention propose en outre un dispositif de synthèse de fréquences, comportant au moins :

- des premiers moyens, ou premier générateur, aptes à générer un signal périodique de fréquence $f_1$,
- des deuxièmes et troisièmes moyens, ou deuxième générateur, couplés aux premiers moyens et aptes à recevoir en entrée le signal périodique de fréquence $f_1$ et à générer au moins un signal $S_G$ correspondant à un train d'oscillations de fréquence sensiblement égale à $N.f_1$, de durée inférieure à $T_1 = 1/f_1$ et répété périodiquement à la

fréquence $f_1$, avec N nombre entier supérieur à 1,

- des quatrièmes moyens, ou troisième générateur, aptes à générer, à partir du signal $S_G$, m signaux périodiques $S_{LO\_CH1}$ à $S_{LO\_CHm}$, par exemple sinusoïdaux, dont les spectres fréquentiels comportent chacun une raie principale, ou pic principal, de fréquence $f_{LO\_CHi}$ correspondant à un multiple entier de $f_1$, avec $1 \leq i \leq m$, i et m étant des nombres entiers, les quatrièmes moyens jouant un rôle de filtre passe-bande appliqué sur le signal $S_G$ et rejetant des spectres fréquentiels de chacun des signaux périodiques $S_{LO\_CH1}$ à $S_{LO\_CHm}$ les raies autres que la raie principale de fréquence $f_{LO\_CHi}$.

Un tel dispositif permet de réaliser une synthèse de fréquences qui soit stabilisée en fréquence et en bruit. Ce dispositif se base sur une multiplication de fréquence d'un signal, ou plus particulièrement une génération, à partir d'une basse fréquence, de signaux périodiques complexes centrés à plus hautes fréquences, et une récupération ultérieure de ces fréquences afin d'obtenir des signaux stabilisés en fréquence. En effet, les deuxièmes et troisièmes moyens génèrent, par exemple via la commande réalisée par les troisièmes moyens sur les deuxièmes moyens, un ou plusieurs signaux périodiques impulsionnels dont la ou les fréquences centrales $f_G$ ou $f_{G1}$ à $f_{Gm}$ sont des multiples d'un premier signal généré de fréquence $f_1$. Les troisièmes moyens peuvent agir sur les deuxièmes moyens comme un ou plusieurs interrupteurs de commande fonctionnant à la fréquence $f_1$. On retrouve ainsi dans le ou les spectres du ou des signaux délivrés par les deuxièmes moyens et troisièmes moyens, correspondant par exemple à un ou plusieurs signaux sinusoïdaux impulsionnels, ou plus généralement un ou plusieurs signaux correspondant à des trains d'oscillations de fréquences sensiblement égale à $N.f_1$ ou $N_i.f_1$,, de durées $T_H$ inférieures à $T_1 = 1/f_1$ et répétés périodiquement à la fréquence $f_1$, avec N et $N_i$ nombres entiers supérieurs à 1, plusieurs raies centrées autour de la fréquence centrale $f_G$ = $N.f_1$ ou des fréquences centrales $f_{Gi} = N_i.f_1$, et espacées de $f_1$ ou d'un multiple de $f_1$ les unes des autres. Les quatrièmes moyens servent ensuite à récupérer, dans ce ou ces spectres, la ou les raies souhaitées et générer en sortie un ou plusieurs signaux périodiques, par exemple sinusoïdaux ou de forme sensiblement sinusoïdale, stables de fréquences centrales multiples de $f_1$.

Le dispositif selon l'invention permet donc de réaliser une synthèse de plusieurs hautes fréquences ($f_{LO\_CH1}$ à $f_{LO\_CHm}$) à partir d'un signal basse fréquence (fréquence $f_1$) et d'un générateur d'impulsions haute fréquence formé par les deuxièmes et troisièmes moyens.

Le dispositif selon l'invention permet de générer les signaux $S_{LO\_CH1}$ à $S_{LO\_CHm}$ à partir d'une structure commune sans faire appel à une structure de rebouclage et de stabilisation spécifique pour chacun de ces signaux, et sans faire appel à de nombreux oscillateurs locaux. De plus, les signaux $S_{LO\_CH1}$ à $S_{LO\_CHm}$ ainsi synthétisés sont tous synchronisés en phase du fait qu'ils sont générés à partir du même signal périodique de fréquence $f_1$.

Le dispositif selon l'invention permet de réaliser, entre la fréquence $f_1$ et les fréquences $f_{LO\_CH1}$ à $f_{LO\_CHm}$ délivrées, une multiplication de fréquence d'ordre élevé sans présenter les inconvénients des multiplicateurs de fréquence de l'art antérieur. Le dispositif selon l'invention n'utilise pas de chaîne de multiplicateurs de fréquence traditionnels comme dans certains des dispositifs de synthèse de fréquence de l'art antérieur et a donc pour avantage de réduire la consommation et la taille du dispositif de synthèse de fréquence. De plus, la fréquence synthétisée est programmable via la programmation du paramètre N et du choix des multiples de $f_1$ récupérés.

Le dispositif selon l'invention a donc pour avantages, par rapport aux dispositifs de synthèse de fréquence de l'art antérieur comportant de longues chaînes de circuits multiplicateurs ou diviseurs de fréquence, de réduire la consommation électrique du dispositif, d'améliorer les performances de la synthèse de fréquences réalisée en termes de bruit de phase et de plage de fonctionnement fréquentiel, et de réduire également la complexité du design du dispositif.

Le dispositif de synthèse de fréquences selon l'invention ne fait pas appel à une longue chaîne de diviseurs de fréquence (source de consommation et de surface occupée importantes), ni à une PLL fonctionnant à haute fréquence (source d'instabilités à haute fréquence).

Le dispositif selon l'invention est particulièrement adapté pour fonctionner au sein d'un système de communication émettant et recevant des signaux dans de larges bandes de fréquences RF, et divisant la bande totale d'émission et/ou réception en plusieurs sous-bandes de fréquences lors d'une transposition depuis et/ou vers la bande de base ou des fréquences intermédiaires des signaux RF transmis et/ou reçus.

Les signaux délivrés par les quatrièmes moyens peuvent correspondre à des signaux périodiques dont les spectres fréquentiels comportent des raies de fréquences multiples entiers de $f_1$ et dont les raies principales (présentant la plus grande amplitude parmi l'ensemble des raies spectrales au sein du spectre de chaque signal) se trouvent aux fréquences $f_{LO\_CHi} = (N+i-1).f_1$.

Il est également proposé un dispositif de synthèse de fréquences comportant au moins :

- des moyens aptes à générer un signal périodique de fréquence $f_1$,
- des moyens aptes à générer, à partir du signal périodique de fréquence $f_1$, au moins un signal périodique impulsionnel dont une fréquence centrale $f_G$ est égale à $N.f_1$, avec N nombre entier supérieur à 1, le signal périodique impulsionnel ayant périodiquement une valeur nulle sur une partie de la période du signal périodique de fréquence $f_1$,

- des moyens aptes à générer, à partir du signal périodique impulsionnel de fréquence centrale $f_G$ égale à $N.f_1$, des signaux périodiques, par exemple, sinusoïdaux, de fréquence $f_{LO\_CHi}$ correspondant à des multiples entiers de $f_1$.

Les signaux périodiques $S_{LO\_CH1}$ à $S_{LO\_CHm}$ peuvent être des signaux sensiblement sinusoïdaux présentant chacun une enveloppe sensiblement constante.

Les deuxièmes moyens peuvent comporter au moins un oscillateur commandé en tension dont une plage d'oscillation libre inclut la fréquence centrale $f_G$, c'est-à-dire $N.f_1$, la valeur de N pouvant être fonction d'une valeur d'une première tension de commande destinée à être appliquée en entrée de l'oscillateur commandé en tension. La plage d'oscillation libre peut être définie comme étant la gamme de fréquences comprises entre la fréquence minimale et la fréquence maximale atteignables par l'oscillateur commandé en tension en fonction de la première tension de commande.

Les troisièmes moyens peuvent être aptes à générer une tension d'alimentation des deuxièmes moyens sous la forme d'un autre signal périodique de fréquence $f_1$ dont le rapport cyclique peut être inférieur à 1.

Les troisièmes moyens peuvent comporter au moins un interrupteur relié à une entrée d'alimentation électrique des deuxièmes moyens et apte à être commandé par le signal périodique de fréquence $f_1$ destiné à être généré par les premiers moyens.

Les troisièmes moyens peuvent comporter au moins un interrupteur relié à une entrée d'alimentation électrique de l'oscillateur et apte à être commandé par le signal périodique de fréquence $f_1$ tel qu'il génère une tension d'alimentation de l'oscillateur non nulle seulement pendant une partie de chaque période $T_1$.

Les troisièmes moyens peuvent comporter au moins un interrupteur relié à une sortie de l'oscillateur et apte à être commandé par le signal périodique de fréquence $f_1$ tel qu'il coupe une liaison électrique entre la sortie de l'oscillateur et l'entrée des quatrièmes moyens pendant une partie de chaque période $T_1$.

Les fréquences $f_{LO\_CHi}$ peuvent être égales à des fréquences $(N+i-1).f_1$.

Les deuxièmes moyens peuvent comporter m oscillateurs commandés en tension aptes à générer m signaux $S_{G1}$ à $S_{Gm}$ correspondant chacun à un train d'oscillations de fréquence sensiblement égale à $N_i.f_1$, de durée inférieure à $T_1 = 1/f_1$ et répété périodiquement à la fréquence $f_1$, avec $N_i$ nombres entiers supérieurs à 1, dont des plages d'oscillation libre incluent les fréquences $N_i.f_1$, les valeurs de $N_i$ étant fonction de valeurs de premières tensions de commande destinées à être appliquées en entrées des oscillateurs commandés en tension, et pouvant comporter en outre un ou plusieurs interrupteurs chacun relié à une entrée d'alimentation électrique d'un des oscillateurs et apte à être commandé par le signal périodique de fréquence $f_1$ tel qu'il génère une tension d'alimentation d'un des oscillateurs non nulle seulement pendant une partie de chaque période $T_1$ et/ou un ou plusieurs interrupteurs chacun relié à une sortie d'un des oscillateurs et apte à être commandé par le signal périodique de fréquence $f_1$ tel qu'il coupe une liaison électrique entre la sortie d'un des oscillateurs et l'entrée des quatrièmes moyens pendant une partie de chaque période $T_1$, les interrupteurs pouvant former les troisièmes moyens, et les quatrièmes moyens pouvant être aptes à générer les m signaux périodiques $S_{LO\_CH1}$ à $S_{LO\_CHm}$ à partir des signaux $S_{G1}$ à $S_{Gm}$.

Dans ce cas, les fréquences $f_{LO\_CHi}$ peuvent être égales aux fréquences $N_i.f_1$ et/ou les fréquences $N_i.f_1$ peuvent être des multiples entiers consécutifs de la fréquence $f_1$. Ainsi, les signaux $S_{LO\_CH1}$ à $S_{LO\_CHm}$ peuvent tous avoir une même amplitude étant donné que ces signaux sont obtenus par la récupération des raies principales des signaux $S_{G1}$ à $S_{Gm}$.

Les quatrièmes moyens peuvent comporter plusieurs circuits récupérateurs de fréquence délivrant chacun en sortie un des m signaux périodiques $S_{LO\_CH1}$ à $S_{LO\_CHm}$, chaque circuit récupérateur de fréquence pouvant comporter au moins un oscillateur verrouillé par injection destiné à recevoir en entrée le signal $S_G$ ou l'un des signaux $S_{G1}$ à $S_{Gm}$ (périodiquement interrompus à la fréquence $f_1$) et à être verrouillé au moins périodiquement à la fréquence $f_{LO\_CHi}$ dont la valeur est fonction d'une valeur d'une deuxième tension de commande destinée à être appliquée en entrée de l'oscillateur verrouillé par injection et/ou chaque circuit récupérateur de fréquence comportant au moins un filtre passe-bande de fréquence centrale sensiblement égale à $f_{LO\_CHi}$.

Dans ce cas, chaque circuit récupérateur de fréquence peut comporter au moins deux oscillateurs verrouillés par injection dont l'un est apte à délivrer en sortie l'un des m signaux périodiques $S_{LO\_CH1}$ à $S_{LO\_CHm}$ et l'autre est apte à délivrer en sortie un autre signal périodique en quadrature de phase avec ledit un des m signaux périodiques $S_{LO\_CH1}$ à $S_{LO\_CHm}$ via un couplage réalisé entre les deux oscillateurs verrouillés par injection ou via un élément déphaseur disposé entre les deuxièmes moyens et les oscillateurs verrouillés par injection.

La valeur de la fréquence $f_1$ peut être supérieure à environ 500 MHz, et/ou les valeurs des fréquences $f_{LO\_CHi}$ peuvent être supérieures à environ 10 GHz, et/ou les oscillations du signal $S_G$ ou des signaux $S_{G1}$ à $S_{Gm}$ peuvent être sinusoïdales.

Les premiers moyens peuvent comporter au moins un dispositif résonateur et une boucle à verrouillage de phase apte à asservir la phase du signal périodique de fréquence $f_1$ délivré par un oscillateur commandé en tension de la boucle à verrouillage de phase sur une phase d'un signal périodique, par exemple un signal sinusoïdal, délivré par le dispositif résonateur. Ainsi, le dispositif de synthèse de fréquence peut faire appel à une boucle à verrouillage de phase fonctionnant à basse fréquence, ce qui permet de supprimer les risques d'instabilité engendrés par une PLL fonctionnant à une haute fréquence comme dans l'art antérieur.

En variante, les premiers moyens peuvent également comporter un dispositif résonateur apte à générer le signal périodique, qui est stable, de fréquence $f_1$.

L'invention concerne également un dispositif d'émission et/ou de réception de signaux, comportant au moins un dispositif de synthèse de fréquences tel que décrit précédemment dont des sorties sur lesquelles sont délivrés les signaux périodiques $S_{LO\_CH1}$ à $S_{LO\_CHm}$ sont reliées à des entrées de mélangeurs du dispositif d'émission et/ou de réception aptes à réaliser une transposition de fréquences des signaux destinés à être émis et/ou reçus.

Il est également proposé un procédé de synthèse de fréquences, comportant au moins les étapes de :

- génération d'un signal périodique de fréquence $f_1$,
- génération, à partir du signal périodique de fréquence $f_1$, d'au moins un signal périodique impulsionnel dont une fréquence centrale $f_G$ est égale à $N.f_1$, avec N nombre entier supérieur à 1, le signal périodique impulsionnel ayant périodiquement une valeur non-nulle seulement sur une partie de chaque période du signal périodique de fréquence $f_1$,
- génération, à partir du signal périodique impulsionnel de fréquence centrale $f_G$, de plusieurs signaux périodiques de fréquence $f_{LO\_CHi}$ correspondant à des multiples entiers de $f_1$.

La présente invention concerne en outre un procédé de synthèse de fréquence, comportant au moins les étapes de :

- génération d'un signal périodique de fréquence $f_1$,
- génération, à partir du signal périodique de fréquence $f_1$, d'au moins un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
- génération, à partir du signal $S_G$, de m signaux périodiques $S_{LO\_CH1}$ à $S_{LO\_CHm}$ dont les spectres fréquentiels comportent chacun une raie principale de fréquence $f_{LO\_CHi}$ correspondant à un multiple entier de $f_1$, avec $1 \leq i \leq m$, i et m étant des nombres entiers, via la mise en oeuvre d'une fonction de filtrage passe-bande appliquée sur le signal $S_G$ et rejetant des spectres fréquentiels de chacun des signaux périodiques $S_{LO\_CH1}$ à $S_{LO\_CHm}$ les raies autres que la raie principale de fréquence $f_{LO\_CHi}$.

Le fait que le signal périodique impulsionnel généré par les deuxièmes moyens ait une valeur non-nulle seulement sur une partie de chaque période du signal périodique de fréquence $f_1$ signifie que ce signal impulsionnel a périodiquement une valeur nulle sur une partie de la période du signal périodique de fréquence $f_1$.

L'invention concerne enfin un procédé de réalisation d'un dispositif de synthèse de fréquences, comportant au moins les étapes de :

- réalisation de premiers moyens aptes à générer un signal périodique de fréquence $f_1$,
- réalisation de deuxièmes et troisièmes moyens, couplés aux premiers moyens et aptes à recevoir en entrée le signal périodique de fréquence $f_1$ et à générer au moins un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
- réalisation de quatrièmes moyens aptes à générer, à partir du signal $S_G$, m signaux périodiques $S_{LO\_CH1}$ à $S_{LO\_CHm}$ dont les spectres fréquentiels comportent chacun une raie principale de fréquence $f_{LO\_CHi}$ correspondant à un multiple entier de $f_1$, avec $1 \leq i \leq m$, i et m étant des nombres entiers, en jouant un rôle de filtre passe-bande appliqué sur le signal $S_G$ et rejetant des spectres fréquentiels de chacun des signaux périodiques $S_{LO\_CH1}$ à $S_{LO\_CHm}$ les raies autres que la raie principale de fréquence $f_{LO\_CHi}$.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- les figures 1 à 3 représentent schématiquement des dispositifs de synthèse de fréquence selon l'art antérieur,
- la figure 4 représente schématiquement une partie d'un dispositif d'émission - réception de signaux RF, objet de la présente invention, selon un mode de réalisation particulier,
- la figure 5 représente les raies principales de signaux $S_{LO\_CH1}$ - $S_{LO\_CHm}$ utilisés par le dispositif d'émission - réception de signaux RF, objet de la présente invention, selon un mode de réalisation particulier,
- la figure 6 représente schématiquement un dispositif de synthèse de fréquences, objet de la présente invention, selon un premier mode de réalisation,

- les figures 7A et 7B représentent respectivement la forme d'onde et le spectre d'un signal $S_C$ généré dans un dispositif de synthèse de fréquences, objet de la présente invention,
- les figures 8A et 8B représentent respectivement la forme d'onde et le spectre d'un signal $S_G$ généré dans un dispositif de synthèse de fréquences, objet de la présente invention,
- les figures 9A et 9B représentent respectivement la forme d'onde et le spectre d'un signal $S_{LO\_CHi}$ obtenu en sortie d'un dispositif de synthèse de fréquences, objet de la présente invention,
- la figure 10 représente la sélectivité d'un circuit récupérateur de fréquence faisant partie d'un dispositif de synthèse de fréquences, objet de la présente invention,
- les figures 11A et 11B représentent des signaux $S_{LO\_CHi}$ obtenus en sortie d'un dispositif de synthèse de fréquences,
- les figures 12A et 12B représentent des formes d'ondes et des spectres des signaux générés dans un dispositif de synthèse de fréquences, objet de la présente invention,
- la figure 13 représente schématiquement un dispositif de synthèse de fréquences, objet de la présente invention, selon un deuxième mode de réalisation,
- la figure 14 représente le spectre d'un signal $S_G$ généré dans un dispositif de synthèse de fréquences, objet de la présente invention,
- la figure 15 représente le spectre d'un signal $S_{LO\_CH1}$ obtenu en sortie d'un dispositif de synthèse de fréquences, objet de la présente invention,
- la figure 16 représente le bruit de phase d'un signal $S_{LO\_CH1}$ obtenu en sortie d'un dispositif de synthèse de fréquences, objet de la présente invention,
- la figure 17 représente schématiquement un dispositif de synthèse de fréquences, objet de la présente invention, selon un troisième mode de réalisation,
- la figure 18 représente les spectres de signaux $S_{G1}$ - $S_{Gm}$ générés dans un dispositif de synthèse de fréquences, objet de la présente invention, selon le troisième mode de réalisation,
- la figure 19 représente un exemple de réalisation d'un circuit récupérateur de fréquence d'un dispositif de synthèse de fréquences, objet de la présente invention,
- la figure 20 représente un exemple de réalisation d'un dispositif de synthèse de fréquences, objet de la présente invention, selon le troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

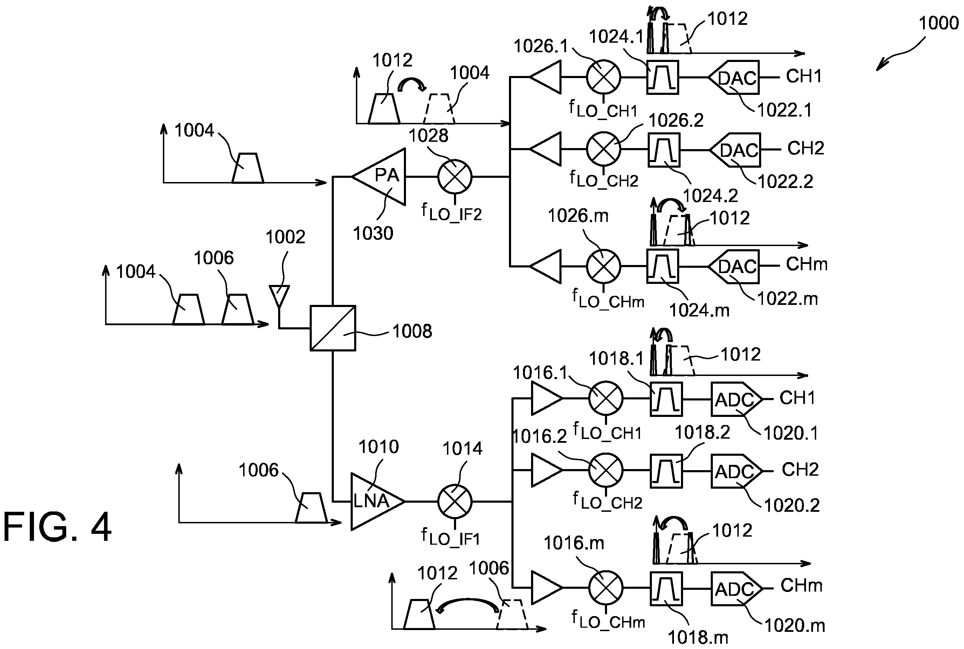

On se réfère tout d'abord à la figure 4 qui représente schématiquement une partie d'un dispositif d'émission - réception 1000 apte à réaliser une émission et une réception de signaux dans une large bande RF, par exemple de type E-band (transmission dans les bandes 71-76 GHZ et 81-86 GHz), et réalisant des transpositions de fréquences en utilisant m canaux permettant une répartition de la large bande RF en m sous-bandes fréquentielles, m étant un nombre entier supérieur à 1.

Le dispositif 1000 comporte une antenne 1002 servant à l'émission et à la réception des données. Dans l'exemple décrit ici, la bande de fréquences utilisée pour l'émission de données, représentée symboliquement avec la référence 1004, est différente de la bande de fréquences utilisée pour la réception de données, représentée symboliquement avec la référence 1006. Le dispositif 1000 comporte également un élément 1008 permettant à l'antenne 1002 de fonctionner conjointement avec les éléments d'émission et les éléments de réception du dispositif 1000.

Lorsqu'un signal est reçu par l'antenne 1002, celui-ci est envoyé, via l'élément 1008, en entrée d'un amplificateur faible bruit (LNA) 1010, puis transposé dans une bande de fréquences intermédiaires 1012 par un mélangeur 1014 recevant en entrée le signal reçu et un signal stable de fréquence $f_{LO\_IF1}$.

En raison de la grande largeur de bande RF utilisée, qui correspond également à la largeur de la bande de fréquences intermédiaires 1012, il n'est pas possible d'utiliser un seul convertisseur analogique numérique pour convertir les signaux se trouvant dans cette bande de fréquences. Cette large bande de fréquences est donc démultiplexée en fréquence afin d'obtenir m sous-bandes de fréquences moins larges réparties sur m canaux comprenant chacun un convertisseur analogique - numérique.

Ce démultiplexage est réalisé sur les m canaux via une seconde transposition de fréquences de m parties de la bande de fréquences intermédiaires 1012 vers m bandes de fréquences intermédiaires plus basses, ou directement en bande de base (directement en bande de base sur l'exemple représenté sur la figure 4). La somme des m parties de la bande de fréquences intermédiaires 1012 forme la totalité de la bande de fréquences intermédiaires 1012. Sur la figure 4, ce démultiplexage, ou seconde transposition de fréquences, est réalisé via m mélangeurs 1016.1 - 1016.m recevant chacun en entrée le signal dans la bande de fréquences intermédiaires 1012 et un signal stable de fréquence centrale adaptée à la partie de la bande de fréquences intermédiaires 1012 destinée à être récupérée et transposée en bande de base dans le canal. Chacun des mélangeurs 1016.1 - 1016.m reçoit donc en entrée, en plus du signal de fréquences intermédiaires, un signal stable de fréquence différente pour chaque canal, ici de fréquences $f_{LO\_CH1}$ à $f_{LO\_CHm}$, ces signaux étant appelés $S_{LO\_CH1}$ à $S_{LO\_CHm}$. Les signaux en bande de base obtenus en sortie des mélangeurs 1016.1 - 1016.m sont ensuite filtrés individuellement par des filtres passe-bande 1018.1 - 1018.m, puis convertis numériquement par des convertisseurs analogiques - numériques 1020.1 - 1020.m, et délivrés sur les canaux CH1 à CHm.

Pour réaliser une émission de signaux, les opérations inverses à celles réalisées lors de la réception précédemment décrite sont mises en oeuvre. Ainsi, les signaux en bande de base des canaux CH1 à CHm sont tout d'abord convertis individuellement par des convertisseurs numériques - analogiques 1022.1 - 1022.m, puis filtrés individuellement par des filtres passe-bande 1024.1 - 1024.m, et transposés dans la bande de fréquences intermédiaires 1012 via un multiplexage dans le domaine fréquentiel réalisé par des mélangeurs 1026.1 - 1026.m recevant chacun en entrée un des signaux analogiques filtrés et un des signaux $S_{LO\_CH1}$ à $S_{LO\_CHm}$. Les signaux se trouvant dans la bande de fréquences intermédiaires 1012 ainsi combinés forment un seul signal réparti sur l'ensemble de la bande de fréquences intermédiaires 1012. Une transposition dans la bande de fréquences 1004 est ensuite réalisée par un mélangeur 1028 recevant en entrée le signal dans la bande de fréquences intermédiaires 1012 ainsi que le signal de fréquence $f_{LO\_IF2}$. Le signal de sortie du mélangeur 1028 est enfin amplifié par un amplificateur de puissance 1030 puis émis par l'antenne 1002.

Les différents canaux CH1 à CHm fonctionnent simultanément lors d'une émission ou d'une réception de données.

Du fait que les sous-bandes de fréquences associées aux signaux de chaque canal, autant pour l'émission que pour la réception, correspondent ici à des parties de largeur identique et disposées les unes à côté des autres dans la bande de fréquences 1004 ou de la bande de fréquences 1006, et donc dans la bande de fréquences intermédiaires 1012, les fréquences $f_{LO\_CH1}$ à $F_{LO\_CHm}$ utilisées pour réaliser la transposition de fréquences depuis ou vers la bande de fréquences intermédiaires 1012 ont pour caractéristique principale d'être régulièrement espacées les unes des autres d'une valeur $\Delta f$. La figure 5 représente les raies principales des signaux $S_{LO\_CH1}$ à $S_{LO\_CHm}$. Ainsi, ces fréquences sont telles que $f_{LO-CH2} = f_{LO-CH1} + \Delta f$, $f_{LO-CH3} = f_{LO-CH2} + \Delta f$, ..., et $F_{LO-CHm} = f_{LO-CHm-1} + \Delta f$, c'est-à-dire $f_{LO-CHi} = f_{LO-CH1} + (i-1).\Delta f$ avec $1 \leq i \leq m$. Les fréquences $f_{LO\_CH1}$ à $f_{LO\_CHm}$ peuvent être chacune un multiple de $\Delta f$, et avantageusement des multiples entiers consécutifs de $\Delta f$ comme c'est le cas sur l'exemple de la figure 4, avec dans cas, lorsque $f_{LO-Ch1} = N.\Delta f$, avec N nombre entier supérieur à 1, des fréquences $f_{LO\_CH1}$ à $f_{LO\_CHm}$ pouvant alors être exprimées par l'équation $f_{LO-CHi} = (N+i-1).\Delta f$.

Selon les sous-bandes de fréquences souhaitées, il est possible que ces fréquences $f_{LO\_CH1}$ à $f_{LO\_CHm}$ soient des multiples entiers non consécutifs de $\Delta f$ et/ou que $f_{LO-Ch1}$ ne soit pas égale à $N.\Delta f$.

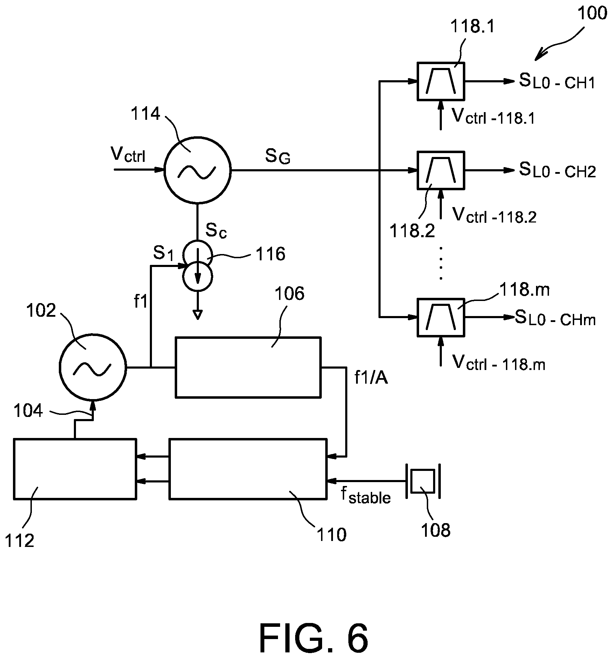

On se réfère maintenant à la figure 6 qui représente un dispositif de synthèse de fréquences 100 selon un premier mode de réalisation, permettant de générer les signaux $S_{LO\_CH1}$ à $S_{LO\_CHm}$ stables en fréquence.

Le dispositif 100 comporte un oscillateur 102 par exemple de type VCO fournissant en sortie un signal périodique $S_1$ de fréquence $f_1$, par exemple sinusoïdal de fréquence d'oscillation $f_1$. La fréquence $f_1$ peut être assimilée à la valeur $\Delta f$ utilisée dans l'exemple du dispositif d'émission - réception 1000 précédemment décrit. La fréquence $f_1$ est contrôlée par une tension appliquée sur une entrée de commande 104 de l'oscillateur 102. Afin de verrouiller et stabiliser la fréquence d'oscillation $f_1$ du signal $S_1$, l'oscillateur 102 est asservi par une boucle de verrouillage de phase (PLL). Cette PLL comporte un ou plusieurs diviseurs de fréquence 106 aptes à diviser la fréquence du signal $S_1$ par un nombre A entier ou fractionnaire. On obtient en sortie du ou des diviseurs de fréquence 106 un signal périodique de fréquence $f_1/A$ qui est ensuite comparé à un signal périodique de référence très stable de fréquence $f_{stable}$ fourni par un résonateur 108, par exemple à quartz. Le facteur A est choisi tel que la fréquence $f_1/A$ soit proche de la fréquence $f_{stable}$. Une comparaison entre ces deux signaux est réalisée par un comparateur de phases 110 (PFD) générant un signal de sortie proportionnel à la différence de phases mesurée entre ces deux signaux, dont la valeur est positive ou négative selon le signe de la différence $f_1/A - f_{stable}$.

Ce signal de sortie est envoyé en entrée d'un circuit de pompe de charge et d'un filtre 112 délivrant en sortie le signal appliqué sur l'entrée de commande 104 de l'oscillateur 102 afin d'ajuster la fréquence d'oscillation $f_1$, de sorte à ce que $f_1/A = f_{stable}$.

Les éléments 102, 106, 108, 110 et 112 permettent d'obtenir le signal périodique $S_1$, par exemple sinusoïdal, qui est stable en fréquence. En variante, il est possible de remplacer ces éléments 102, 106, 108, 110 et 112 par n'importe quel dispositif ou structure apte à fournir un tel signal périodique $S_1$ stable en fréquence, correspondant par exemple à un seul dispositif résonateur lorsqu'un tel dispositif résonateur peut fournir directement le signal $S_1$. Le choix du type de dispositif ou structure générant le signal périodique $S_1$ peut notamment être fait en fonction de la fréquence

$f_1$ souhaitée. Un dispositif résonateur seul peut être suffisant si la fréquence $f_1$ ne dépasse pas une valeur au-delà de laquelle il peut alors être nécessaire de faire appel à une PLL pour générer le signal $S_1$.

Le dispositif de synthèse de fréquences 100 comporte en outre un générateur de train d'oscillations répétées périodiquement (appelé par la suite « TORP ») dans la bande des fréquences à synthétiser et plusieurs circuits récupérateurs de fréquences.

Dans ce premier mode de réalisation, le générateur de TORP est composé d'un oscillateur 114 de type VCO contrôlé en tension par un signal de contrôle $V_{ctrl}$, et des moyens d'alimentation électrique commandés 116 alimentant électriquement l'oscillateur 114 et qui sont commandés par le signal $S_1$ de fréquence $f_1$ délivré par l'oscillateur 102. Sur l'exemple de la figure 6, cette alimentation électrique commandée correspond à une source de courant commandée 116 fonctionnant comme un interrupteur interrompant périodiquement (période $T_1 = 1/f_1$) l'alimentation électrique de l'oscillateur 114. Cette source de courant commandée peut correspondre à un transistor MOS comportant une grille sur laquelle est appliqué le signal $S_1$. De manière générale, ces moyens 116 peuvent comporter un interrupteur relié à une entrée d'alimentation électrique de l'oscillateur 114 et apte à être commandé par le signal périodique $S_1$.

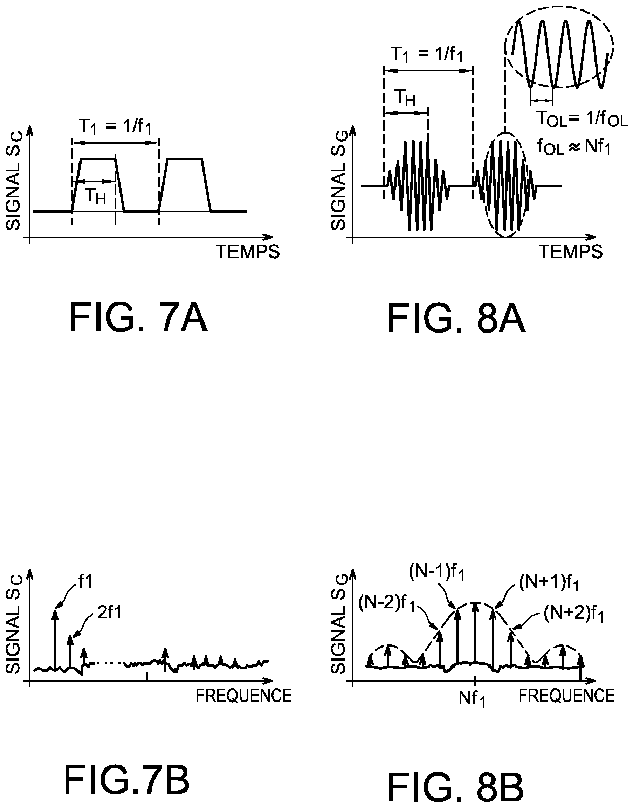

L'oscillateur 114 est donc commuté par cet interrupteur mettant alternativement l'oscillateur 114 en état ON et en état OFF, c'est-à-dire interrompant ou non la fourniture d'un signal de sortie par l'oscillateur 114, successivement à la fréquence $f_1$. L'oscillateur 114 est commandé par un signal $S_C$ correspondant au courant généré par la source de courant 116 (et donc à la tension d'alimentation fournie à l'oscillateur 114) et dont la forme d'onde correspond sensiblement à un signal carré positif de fréquence $f_1$ (ce signal carré n'est pas parfait et peut présenter une forme trapézoïdale, comme c'est le cas du signal $S_C$ représenté sur la figure 7A). Ainsi, lorsque le signal de commutation $S_C$ met l'oscillateur 114 en marche, un signal $S_G$ correspondant à un train d'oscillations est créé à la sortie du VCO 114. Une demi-période $T_1/2$ (avec $T_1 = 1/f_1$) plus tard, l'oscillateur 114 est éteint et l'oscillation est interrompue. L'alternance de l'état ON et de l'état OFF toutes les demi-périodes $T_1/2$ correspond au cas où le signal $S_C$ présente un rapport cyclique égal à 0,5. Le signal $S_C$ représenté sur la figure 7A allume l'oscillateur 114 pendant une durée $T_H$ qui est égale, dans cet exemple, à $T_1/2$.

Toutefois, ce rapport cyclique (égal à $T_H/T_1$) peut être différent de 0,5, et plus généralement compris entre 0 et 1, les valeurs 0 et 1 étant exclues, la durée de l'état ON pouvant être supérieure ou inférieure à celle de l'état OFF.

Ainsi, un signal pulsé $S_G$ est créé à une fréquence centrale $f_{OL}$, correspondant à la fréquence d'oscillation libre de l'oscillateur 114, avec une période de répétition égale à $T_1$. Le signal $S_G$ correspond donc à un TORP, c'est-à-dire ici un train d'oscillations de fréquence $f_{OL}$, de durée inférieure à $T_1 = 1/f_1$ et répété périodiquement avec une période de répétition égale à $T_1$. Le signal $S_G$ a donc périodiquement une valeur nulle sur une partie de chaque période $T_1$, cette partie de chaque période $T_1$ correspondant approximativement à la partie de chaque période $T_1$ au cours de laquelle le signal $S_C$ a une valeur nulle. Le signal $S_G$ a la particularité d'avoir sa phase verrouillée sur celle du signal de fréquence $f_1$ fourni par l'oscillateur 102 et a une fréquence centrale $f_{OL}$ qui est sensiblement égale à un multiple entier de $f_1$ ($f_{OL} \approx N.f_1$). Cette propriété est due au fait qu'au démarrage de l'oscillation, l'oscillateur 114 présente une élasticité élevée et se verrouille facilement sur une harmonique N de la fréquence $f_1$ avec N tel que le produit $N.f_1$ soit le plus proche de la fréquence d'oscillation libre $f_{OL}$ de l'oscillateur 114 lorsqu'il se trouve en oscillation libre. La valeur de N, et donc celle de la fréquence $f_{OL}$, dépendent de la valeur de la tension $V_{ctrl}$ appliquée en entrée de l'oscillateur 114.

Le spectre équivalent du signal $S_G$ présente une enveloppe dont la forme correspond à un sinus cardinal dont les composantes sont des sinusoïdes de fréquence centrale $N.f_1$. Les raies du spectre de $S_G$ sont espacées les unes des autres de $f_1$. Les figures 7A et 7B représentent respectivement la forme d'onde (domaine temporel) et le spectre (domaine fréquentiel) du signal Sc. De même, les figures 8A et 8B représentent respectivement la forme d'onde et le spectre du signal $S_G$. Sur la figure 8A, on voit que dans chaque train d'oscillations du signal $S_G$, les amplitudes des oscillations sont croissantes lors du démarrage de l'oscillateur 114 et sont décroissantes lors de l'arrêt de l'oscillateur 114. De plus, les oscillations des trains d'oscillations de $S_G$ sont similaires, en termes de phase, d'amplitude et de fréquence, d'un train à l'autre.

D'un point de vue analytique, le signal $S_G$ est obtenu par la convolution dans le domaine temporel entre un sinus fenêtré, de fréquence $f_{OL}$ (correspondant à la fréquence d'oscillation libre de l'oscillateur 114) et de largeur de fenêtre égale à $T_H$, avec $T_H \in \,]0,T_1[$, et un peigne de Dirac de période égale à $T_1$. Le signal $S_G$ peut donc s'exprimer sous la forme :

$$S_G(t) = \left[ sin(2 \cdot \pi \cdot f_{OL} \cdot t) \cdot \Pi_{T_H}(t) \right] \otimes \sum_{k=-\infty}^{\infty} \delta(t - k \cdot T_1)$$

$\Pi_{T_H}(t)$ est la fonction de fenêtrage correspondant à :

$$\Pi_{T_H}(t) = \begin{cases} 0 & \forall\, t < 0 \\ 1 & \forall\, t \in \,]0, T_1[ \\ 0 & \forall\, t > T_H \end{cases}$$

Le spectre fréquentiel du signal $S_G$ correspond dans ce cas à :

$$|S_G(f)|_{f>0} = \left[\frac{1}{2}\delta(f - f_{OL}) \otimes T_H \cdot sinc(\pi \cdot f \cdot T_H)\right] \cdot f_1 \cdot \sum_{k=-\infty}^{\infty} \delta(f - k \cdot f_1)$$

Pour chacune des raies de fréquences $f_j$ du spectre du signal $S_G$ ($f_j$ étant des multiples de $f_1$), l'amplitude $A_j$ de chacune de ces raies peut être exprimée par l'équation :

$$A_j = \frac{1}{2} sin\, c\big(\pi\big(f_j - f_{OL}\big)T_H\big)$$

Le signal $S_G$ est ensuite utilisé pour obtenir en sortie du dispositif 100 les signaux $S_{LO\_CH1}$ à $S_{LO\_CHm}$ correspondant à des signaux périodiques, par exemple sinusoïdaux, dont les spectres fréquentiels comportent chacun une raie, ou pic, principale, c'est-à-dire de plus forte valeur par rapport aux autres raies, de fréquences $f_{LO\text{-}CH1}$ à $F_{LO\text{-}CHm}$ correspondant aux fréquences à synthétiser par le dispositif 100 et correspondant chacune à l'une des fréquences $f_j$ du spectre du signal $S_G$. Aussi, afin d'obtenir ces spectres correspondant, ou s'approchant, chacun d'un sinus pur sans les raies adjacentes à la fréquence centrale $f_{LO\text{-}CHi}$, avec $1 \le i \le m$, le dispositif 100 comporte plusieurs circuits de récupération de fréquence 118.1 à 118.m, ou circuits de récupération de raie, dont les entrées sont reliées à la sortie de l'oscillateur pulsé 114. Les circuits récupérateurs de fréquence 118.1 à 118.m jouent le rôle de filtres passe-bande et rejettent chacun les raies adjacentes à la fréquence $f_{LO\text{-}CHi}$ à récupérer. On obtient, à la sortie des circuits récupérateurs de fréquence 118.1 à 118.m, les signaux périodiques $S_{LO\text{-}CH1}$ à $S_{LO\_CHm}$ dont les raies principales ont chacune pour fréquence un multiple de $f_1$, par exemple un signal sinusoïdal avec une enveloppe sensiblement constante dont la fréquence $f_{LO\text{-}CHi}$ est un multiple de $f_1$.

En considérant la fréquence $f_{LO\text{-}CHi}$ correspondant à la raie principale du signal $S_{LO\_CHi}$ comme égale à $(N+i-1).f_1$, le bruit de phase du signal $S_{LO\_CHi}$ est égal au bruit de phase du signal $S_1$ plus $20log(N+i-1)$ :

$$Ph(N+i-1)_{dBc/Hz}^{f_{LO\text{-}CHi}} = Ph(N+i-1)_{dBc/Hz}^{f_1} + 20log(N+i-1)$$

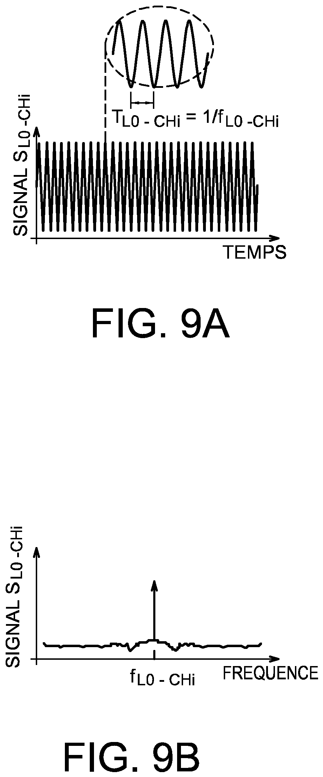

Les figures 9A et 9B représentent respectivement la forme d'onde (domaine temporel) et le spectre (domaine fréquentiel) d'un des signaux $S_{LO\_CH1}$ à $S_{LO\_CHm}$, appelé $S_{LO\_CHi}$. Ainsi, on obtient en sortie du dispositif 100 un signal $S_{LO\_CHi}$ de spectre pur, c'est-à-dire comportant une unique raie à la fréquence $f_{LO\text{-}CHi}$ verrouillée sur $f_{stable}$, toutes les autres composantes non désirées ayant été rejetées en dehors du spectre fréquentiel du signal $S_{LO\_CHi}$ par le circuit récupérateur de fréquence 118.i.

Les oscillateurs 102 et 114 sont par exemple réalisés sous la forme de paires croisées différentielles (résonateurs couplés avec une résistance négative).

L'oscillateur 114 peut par exemple être réalisé comme décrit dans le document « A 60 GHz UWB impulse radio transmitter with integrated antenna in CMOS65nm SOI technology » de A. Siligaris et al., Silicon Monolithic Integrated Circuits in RF Systems (SiRF), 2011 IEEE 11th Topical Meeting on, pp. 153-156, 17-19 Jan. 2011. L'oscillateur 102 peut par exemple être réalisé comme décrit dans le document « A 17.5-to-20.94GHz and 35-to-41.88GHz PLL in 65nm CMOS for wireless HD applications » de O. Richard et al., Solid-State Circuits Conférence Digest of Technical Papers (ISSCC), 2010 IEEE International, pp.252-253, 7-11 Feb. 2010.

Les circuits récupérateurs de fréquence 118.1 à 118.m jouent chacun un rôle de filtre passe-bande de très haute sélectivité, et peuvent correspondre chacun à un circuit oscillateur verrouillé, ou synchronisé, par injection (ILO) ou plusieurs circuits ILO disposés en cascade. La réalisation d'un tel ILO est par exemple décrite dans le document « A 50 GHz direct injection locked oscillator topology as low power frequency divider in 0.13 $\mu$m CMOS » de M. Tiebout, Solid-State Circuits Conference, 2003. ESSCIRC '03. Proceedings of the 29th European, pp. 73- 76, 16-18 Sept. 2003.

Un tel circuit oscillateur fonctionne en continu et en l'absence de signal $S_G$ appliqué en entrée (lorsque le signal $S_G$ a périodiquement une valeur nulle), chacun des circuits 118.1 à 118.m délivre en sortie un signal sinusoïdal d'oscillation libre dont la fréquence $f_{osc\_libre\_118.i}$ est dans la même bande de fréquence que $f_{LO-CHi}$ ($f_{osc\_libre\_118.i} \approx f_{LO-CHi}$). La valeur de la fréquence $f_{osc\_libre\_118.i}$ dépend de la valeur d'un signal de contrôle $V_{ctrl\_118.i}$ appliqué sur une autre entrée du circuit récupérateur de fréquence 118.i.

Lorsque sa première entrée est excitée par le signal $S_G$ pulsé délivré par l'oscillateur 114, le circuit récupérateur de fréquence 118.i se verrouille à la raie du signal $S_G$ la plus proche de $f_{osc\_libre\_118.i}$. Le signal de contrôle $V_{ctrl\_118.i}$ permet de positionner $f_{osc\_libre\_118.i}$ proche de $(N+i-1).f_1$ afin de centrer le signal $S_{LO\_CHi}$ exactement sur la fréquence $(N+i-1).f_1$. Il est donc possible de verrouiller chacun des circuits récupérateurs de fréquence 118.1 à 118.m sur une raie à $(N+i-1).f_1$ si le signal de contrôle $V_{ctrl\_118.i}$ est tel que $f_{osc\_libre\_118.i}$ se situe proche de la raie $(N+i-1).f_1$. Les signaux $S_{LO\_CH1}$ à $S_{LO\_CHm}$ obtenus sont donc bien synchronisés en phase les uns avec les autres.

Les fréquences $f_{LO-CHi}$, avec $1 \leq i \leq m$, synthétisables par le dispositif 100 sont donc paramétrables et par exemple égales à $(N+i-1).f_1$.

La programmation, ou le réglage, des valeurs des fréquences $f_{LO-CHi}$ synthétisées s'effectue donc via les paramètres N et/ou i et/ou $f_1$.

Dans ce mode de réalisation avantageux, le signal $V_{ctrl\_118.i}$ est choisi tel que $f_{LO\_CH1} = N.f_1$. Ainsi, la fréquence de la raie du signal $f_{LO\_CH1}$ correspond à la fréquence $f_G$, c'est-à-dire la fréquence de la raie principale du signal $S_G$. Les signaux $V_{ctrl\_118.2}$ à $V_{ctrl\_118.m}$ appliqués en entrée des autres circuits récupérateurs de fréquence 118.2 à 118.m sont en outre tels que les fréquences $f_{LO\_CH2}$ à $f_{LO\_CHm}$ des signaux $S_{LO\_CH2}$ à $S_{LO\_CHm}$ correspondent aux multiples entiers suivants de $f_1$, c'est-à-dire tels que $f_{LO\_CHi} = (N+i-1).f_1$.

En variante, il est possible que le signal $V_{ctrl\_118.1}$ soit choisi tel que la fréquence de la raie du signal $f_{LO\_CH1}$ correspond un multiple de $f_1$ autre que la fréquence $f_G$, c'est-à-dire une fréquence adjacente de la fréquence de la raie principale du signal $S_G$.

De plus, il est également possible que les fréquences $f_{LO\_CH1}$ à $f_{LO\_CHm}$ soient des multiples entiers non consécutifs de $f_1$.

La fréquence $f_G$ peut être modifiée via la valeur du signal de contrôle $V_{ctrl}$ de l'oscillateur 114 d'une part, et les fréquences $f_{LO\_CHi}$ peuvent être modifiées par les valeurs des signaux de contrôle $V_{ctrl\_118.i}$ appliqués en entrée des circuits récupérateurs de fréquence 118.1 à 118.m d'autre part.

Une première possibilité de programmation de la valeur de la fréquence $f_{LO\_CH1}$ (ou d'une autre des fréquences $f_{LO\_CHi}$) consiste à verrouiller l'oscillateur 114 directement sur la fréquence désirée en sortie tel que $f_{OL} = f_{LO\_CH1} = N.f_1$. En effet, comme expliqué précédemment, au démarrage de l'oscillation, l'oscillateur 114 présente une élasticité élevée et a tendance à se verrouiller facilement sur une harmonique N de la fréquence $f_1$. La valeur de la fréquence d'oscillation de l'oscillateur 114 $f_{OL}$ est donc fixée en réglant la valeur de $V_{ctrl}$ telle que $f_{OL} = f_{LO\_CH1} = N.f_1$. La fréquence centrale $f_{OL}$ du spectre de l'oscillateur 114 se verrouille alors sur la raie $N.f_1$. Le circuit récupérateur de fréquence 118.1 (ou l'un des autres circuits récupérateurs de fréquence 118.i si la fréquence programmée correspond à la fréquence $f_{LO\_CHi}$) voit alors à son entrée un signal $S_G$ dont le spectre est un sinus cardinal de raies espacées de $f_1$ dont la raie centrale se trouve à $f_{OL} = f_G = N.f_1$. Le signal de contrôle $V_{ctrl\_118.1}$ du circuit récupérateur de fréquence 118.1 est choisi pour que le verrouillage ait lieu sur la raie centrale, à la fréquence $f_{OL}$.

Ainsi, dans cette première programmation possible de la valeur de $f_{LO\_CH1}$, la valeur de la fréquence synthétisée $f_{LO\_CH1}$ est choisie via le choix de la valeur du signal de contrôle $V_{ctrl}$ de l'oscillateur 114 (déterminant la valeur de N), la valeur du signal de contrôle $V_{ctrl\_118.1}$ du circuit récupérateur de fréquence 118.1 étant constante.

Une deuxième possibilité pour régler la valeur de $f_{LO\_CH1}$ (ou d'une autre des fréquences $f_{LO\_CHi}$) consiste à verrouiller l'oscillateur 114 sur une fréquence $f_{OL} = N.f_1$ avec N fixe (c'est-à-dire $V_{ctrl}$ de valeur constante). Le spectre du signal de sortie $S_G$ est un sinus cardinal de raies espacées de $f_1$ dont la raie centrale est à la fréquence $f_{OL}$. Le signal de contrôle $V_{ctrl\_118.1}$ du circuit récupérateur de fréquence 118.1 (ou de l'un des autres circuits récupérateurs de fréquence 118.i si la fréquence programmée correspond à la fréquence $f_{LO\_CHi}$) est ensuite choisi pour que le verrouillage ait lieu sur une des raies adjacentes à la raie centrale $f_{OL}$ correspondant à la fréquence $f_{LO\_CH1}$ recherchée, de préférence dans le lobe principal du spectre en sinus cardinal. Dans ce deuxième exemple de programmation, la valeur de la fréquence synthétisée $f_{LO\_CH1}$ est choisie via le choix de la valeur du signal de contrôle $V_{ctrl\_118.1}$ du circuit récupérateur de fréquence 118.1, la valeur du signal de contrôle $V_{ctrl}$ de l'oscillateur 114 étant constante et choisie pour que la valeur de N soit telle que la raie de fréquence $f_{LO\_CH1}$ se situe dans le lobe principal du spectre en sinus cardinal de raie centrale à la fréquence $f_{OL}$ telle que $f_{OL} = N.f_1$).

Dans une troisième possibilité de programmation de la valeur de $f_{LO\_CH1}$ (ou d'une autre des fréquences $f_{LO\_CHi}$), il est possible de combiner les deux possibilités précédentes. Il s'agit alors de jouer à la fois sur le signal de contrôle $V_{ctrl}$ de l'oscillateur 114 (jouant sur la valeur de N) et sur le signal de contrôle $V_{ctrl\_118.1}$ du circuit récupérateur de fréquence 118.1 pour synthétiser la fréquence $f_{LO\_CH1}$ souhaitée.

Quelque soit la possibilité de programmation choisie parmi celles exposées précédemment, les valeurs des fréquences $f_{LO\_CH1}$ à $f_{LO\_CHm}$ peuvent également être modifiées via le réglage ou le choix de la valeur de la fréquence $f_1$ étant donné que la valeur de $f_1$ correspond à l'espacement des raies dans le spectre du signal $S_G$, et donc à l'espacement entre les fréquences $f_{LO\_CH1}$ à $f_{LO\_CHm}$.

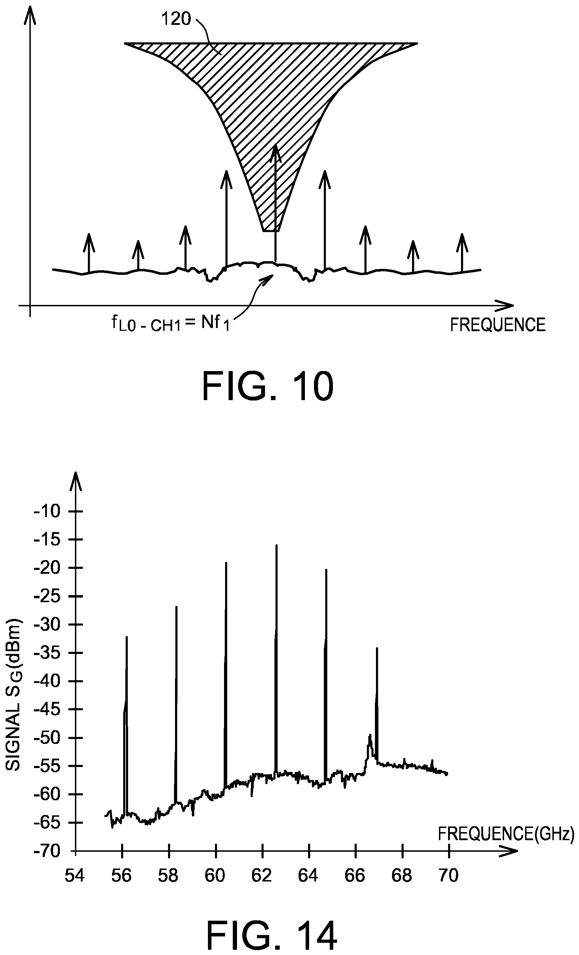

Chacun des circuits récupérateurs de fréquence 118.1 à 118.m permet de sélectionner une raie du spectre du signal $S_G$ délivré par l'oscillateur 114, ces raies se trouvant de préférence dans le lobe principal du spectre du signal $S_G$ (les fréquences $f_{LO\_CH1}$ à $f_{LO\_CHm}$ correspondant donc de préférence à des fréquences des raies du lobe principal du spectre du signal $S_G$). Chacun de ces circuits agit à la fois comme un filtre passe-bande très sélectif et comme un régénérateur de signal, par le biais du verrouillage réalisé sur la fréquence $(N+i-1).f_1$. La sélectivité du circuit récupérateur de fréquence 118.1, lorsque celui-ci correspond à un circuit de type oscillateur verrouillé par injection (ILO), est par exemple représenté sur la figure 10. La zone référencée 120 représente la plage de verrouillage d'un tel ILO qui, sur l'exemple de la figure 10, se verrouille sur la raie centrale du spectre du signal $S_G$ qui est la plus proche de sa fréquence d'oscillation libre.

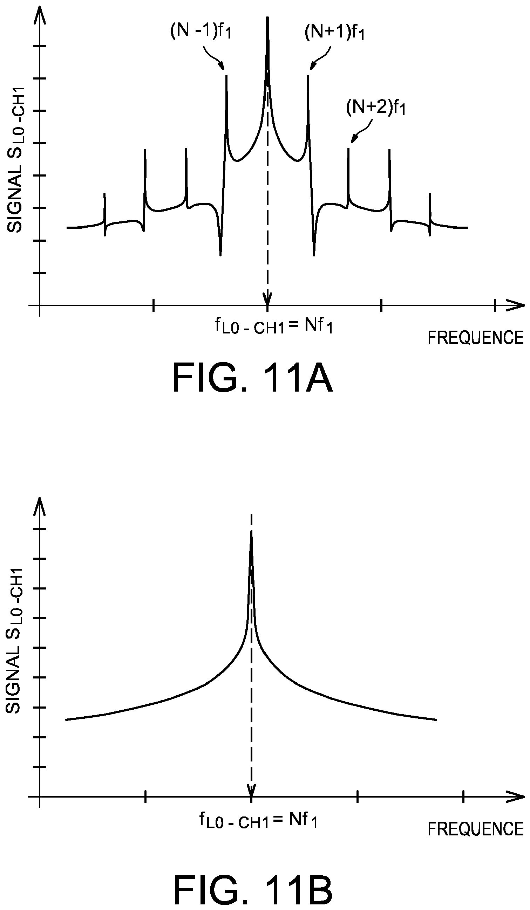

Le signal de sortie de cet ILO est composé principalement de cette raie mais la réjection des raies adjacentes n'est pas infinie. Ainsi, le signal $S_{LO\_CHi}$ obtenu en sortie du circuit récupérateur de fréquence 118.i peut correspondre non pas à un signal sinusoïdal pur, mais à un signal périodique dont l'enveloppe n'est jamais nulle (contrairement au signal $S_G$ dont l'enveloppe est périodiquement nulle) et dont le spectre fréquentiel présente une raie principale à la fréquence $f_{LO\_CHi}$. Les raies secondaires de ce spectre, se trouvant à des fréquences multiples de $f_1$, sont atténuées par rapport aux raies secondaires du spectre du signal $S_G$. La figure 11A représente le spectre du signal $S_{LO\_CH1}$ obtenu par exemple avec le circuit récupérateur de fréquence 118.1 comprenant un seul ILO. Il est possible d'augmenter cette réjection en reliant en cascade (c'est-à-dire en série) un ou plusieurs autres ILO pour former le circuit récupérateur de fréquence 118.i et atténuer ainsi encore plus les raies secondaires du spectre du signal $S_{LO\_CHi}$, ce qui permet d'améliorer la constance de l'enveloppe du signal $S_{LO\_CHi}$. La figure 11B représente le spectre du signal $S_{LO\_CH1}$ obtenu par exemple avec le circuit récupérateur de fréquence 118.1 comprenant plusieurs ILO reliés en cascade. On voit sur cette figure que le signal $S_{LO\_CH1}$ correspond donc quasiment à un signal sinusoïdal pur. Cela s'applique également aux autres signaux $S_{LO\_CHi}$.

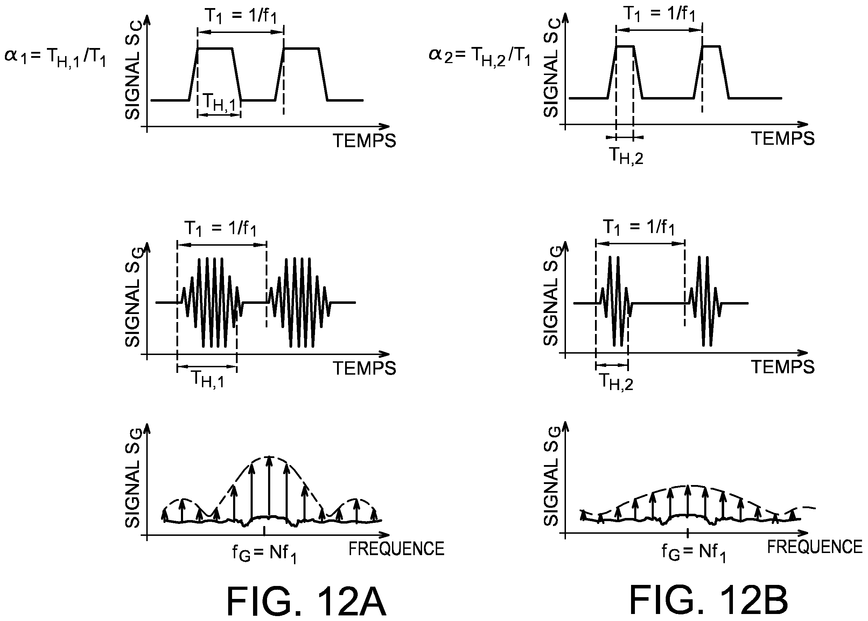

Concernant la forme du spectre du signal $S_G$, plus le rapport cyclique de ce signal est faible, plus le premier lobe du sinus cardinal est large. Ainsi, un petit rapport cyclique implique la présence d'un plus grand nombre de raies dans le lobe principal du spectre du signal $S_G$. Ce principe est illustré sur les figures 12A et 12B qui représentent les formes d'ondes des signaux $S_C$ et $S_G$, et le spectre du signal $S_G$, pour deux signaux $S_C$ de rapports cycliques $\alpha_1$ $(=T_{H1}/T_1)$ et $\alpha_2$ $(=T_{H2}/T_1)$ différents, le rapport cyclique $\alpha_1$ du signal $S_C$ représenté sur la figure 12A étant supérieure au rapport cyclique $\alpha_2$ du signal $S_C$ représenté sur la figure 12B.

En variante, chacun des circuits récupérateurs de fréquence 118.1 à 118.m, ou une partie de ces circuits, peut correspondre à un ou plusieurs filtres passe-bande reliés en cascade. Ce ou ces filtres formant le circuit récupérateur de fréquence 118.i sont réalisés tels que leur fréquence centrale soit proche de la raie du signal $S_G$ de fréquence $(N+i-1).f_1$, ce qui permet de filtrer le signal $S_G$ et récupérer la raie de fréquence $(N+i-1).f_1$ correspondant à la fréquence $f_{LO\_CHi}$ souhaitée. Ce ou ces filtres sont également réalisés tels qu'ils soient très sélectifs. Ce ou ces filtres peuvent être réalisés de plusieurs façons, par exemple sous la forme de filtre BAW (à ondes acoustiques de volume), LC (à partir d'inductances et de capacités) ou encore de filtre SAW (à ondes acoustiques de surface). De plus, il est également possible que le circuit récupérateur de fréquence 118.i comporte un ou plusieurs ILO et un ou plusieurs filtres passe-bande reliés en cascade.

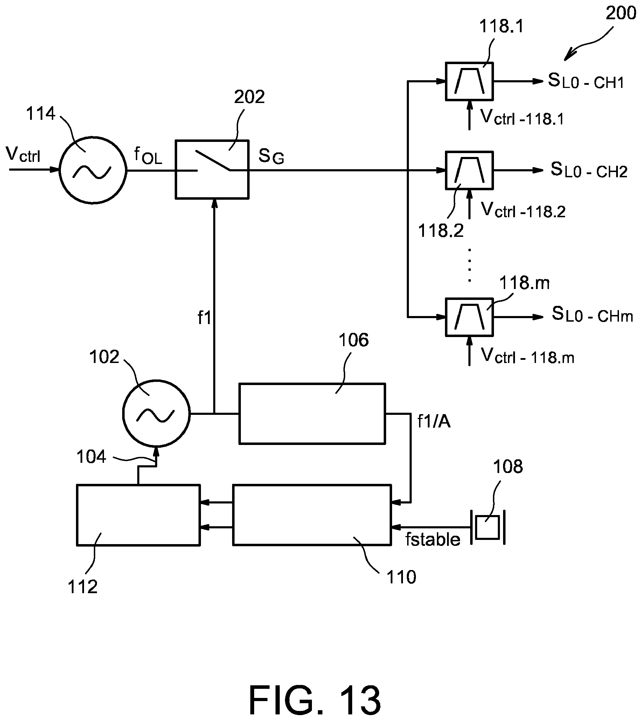

On se réfère à la figure 13 qui représente un dispositif de synthèse de fréquences 200 selon un deuxième mode de réalisation.

Par rapport au dispositif 100 précédemment décrit, l'oscillateur 114 n'est plus commandé par une source d'alimentation interrompue périodiquement, mais est alimenté en continu, fournissant un signal sinusoïdal de fréquence $f_{OL}$. Ce signal est envoyé en entrée d'un interrupteur 202 commandé par le signal périodique $S_1$. L'interrupteur 202 est périodiquement (période $T_1$) en position fermée pendant une durée égale à $T_H$ (par exemple égale à $T_1/2$ dans le cas d'un rapport cyclique de 0,5) et en position ouverte pendant une durée égale à $T_1 - T_H$.

On obtient dans ce cas, en entrée des circuits 118.1 à 118.m, un signal $S_G$ de type TORP, c'est-à-dire de type train d'oscillations de fréquence $f_{OL}$ répété périodiquement avec une période de répétition égale à $T_1$. Les oscillations des trains d'oscillations de $S_G$ ne sont généralement pas similaires, en termes de phase, d'un train à l'autre.

D'un point de vue analytique, ce signal $S_G$ correspond au produit d'un sinus de fréquence $f_{OL}$ (la fréquence d'oscillation libre de l'oscillateur 114) et d'un signal carré périodique de période $T_1$ et d'une durée à l'état haut $T_H$ avec $T_H \in \left]0, T_1\right[$ tel que :

$$S_G(t) = sin(2 \cdot \pi \cdot f_{OL} \cdot t) \cdot \left[ \Pi_{T_H}(t) \otimes \sum_{k=-\infty}^{\infty} \delta(t - k \cdot T_1) \right]$$

Le spectre fréquentiel du signal $S_G$ correspond dans ce cas à :

$$\left| S_G(f) \right|_{f>0} = \frac{1}{2}\delta(f - f_{OL}) \otimes \left[ T_H \cdot \operatorname{sinc}(\pi \cdot f \cdot T_H) \cdot f_1 \cdot \sum_{k=-\infty}^{\infty} \delta(f - k \cdot f_1) \right]$$

Pour chacune des raies de fréquences $f_j$ du spectre du signal $S_G$ (avec $f_j = f_{OL} + j.f_1$, et j nombre entier positif, négatif ou nul), l'amplitude $A_j$ de chacune de ces raies peut être exprimée par l'équation :

$$A_j = \frac{T_H}{2.T_1} sin\, c\left( \pi\, . j\, \frac{T_H}{T_1} \right)$$

Les différentes variantes de réalisation des circuits récupérateurs de fréquence 118.1 à 118.m précédemment décrites pour le dispositif de synthèse de fréquences 100 peuvent s'appliquer également au dispositif de synthèse de fréquences 200.

On décrit ci-dessous un exemple de réalisation du dispositif de synthèse de fréquences 100.

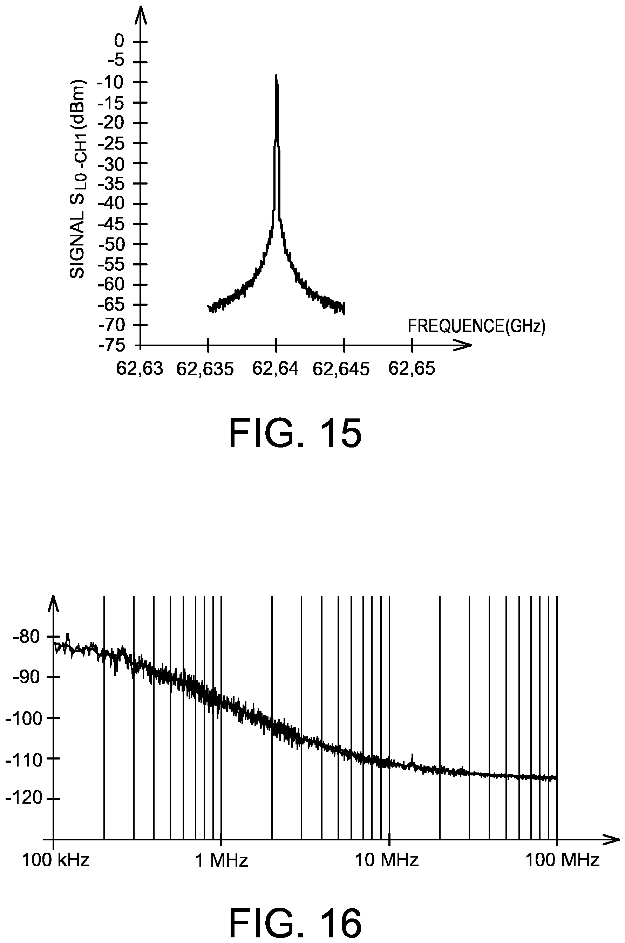

La PLL fournissant le signal $S_1$, la source de courant 116 et l'oscillateur 114 ainsi que les circuits récupérateurs de fréquence 118.1 à 118.m sont réalisés par exemple en technologie CMOS 65 nm par exemple sur SOI afin d'obtenir par exemple un dispositif de synthèse de fréquences conforme à la norme IEEE.802.15.3c relative aux réseaux WPAN, WirelessHD ou WiGig, dans lesquels les transmissions de signaux sont par exemple réalisées dans une gamme de fréquences comprise entre environ 57 GHz et 66 GHz. Les éléments 102, 106, 108, 110 et 112 sont réalisés afin d'obtenir en sortie de l'oscillateur 102 un signal $S_1$ de fréquence $f_1$ égale à environ 2,16 GHz avec un signal de référence $f_{stable}$ = 36 MHz. L'oscillateur 114 est par exemple réalisé afin de délivrer en sortie un signal $S_G$ dont le spectre est représenté sur la figure 14. On voit sur ce spectre que les différentes raies, représentant les différents canaux de communication possibles selon les normes de communication, sont bien espacées de $f_1$ les unes des autres. Les tensions de commande $V_{ctrl}$ et $V_{ctrl\_118.1}$ à $V_{ctrl\_118.m}$ sont choisies telles que les circuits récupérateurs de fréquence 118.1 à 118.m délivrent des signaux $S_{LO\_CH1}$ à $S_{LO\_CHm}$ de fréquence correspondant aux différentes raies du spectre de $S_G$. La tension de commande $V_{ctrl\_118.1}$ est par exemple choisie telle que le circuit récupérateur de fréquence 118.1 délivre un signal $S_{LO\_CH1}$ de fréquence $f_{LO\_CH1}$ = 62,64 GHz. Le spectre du signal $S_{LO\_CH1}$ obtenu en sortie d'un tel dispositif de synthèse de fréquences 100 est représenté sur la figure 15. Enfin, le bruit de phase de ce signal $S_{LO\_CH1}$ est représenté sur la figure 16. Ceci s'applique également pour la réalisation du dispositif de synthèse de fréquences 200.

Le dispositif de synthèse de fréquences 100 ou 200 peut également être utilisé dans un système de transmission RF 1000 tel que celui précédemment décrit en liaison avec la figure 4, permettant de fournir aux mélangeurs 1026.1 à 1026.m et aux mélangeurs 1016.1 à 1016.m les signaux $S_{LO\_CH1}$ à $S_{LO\_CHm}$ de fréquence $f_{LO\_CH1}$ à $f_{LO\_CHm}$.

Dans les modes de réalisation et variantes de réalisation du dispositif de synthèse de fréquences 100 et 200 précédemment décrits, les signaux $S_{LO\_CH1}$ à $S_{LO\_CHm}$ obtenus en sortie sont tous synchronisés en phase les uns avec les autres du fait que ces signaux sont obtenus à partir d'un même signal $S_G$. Par contre, du fait que le spectre du signal $S_G$ présente une enveloppe dont la forme correspond à un sinus cardinal centré sur la fréquence $f_G$, les amplitudes des signaux $S_{LO\_CH1}$ à $S_{LO\_CHm}$ obtenus correspondent aux amplitudes des raies des fréquences récupérées qui varient, les amplitudes des signaux $S_{LO\_CH1}$ à $S_{LO\_CHm}$ étant donc différentes les unes des autres.

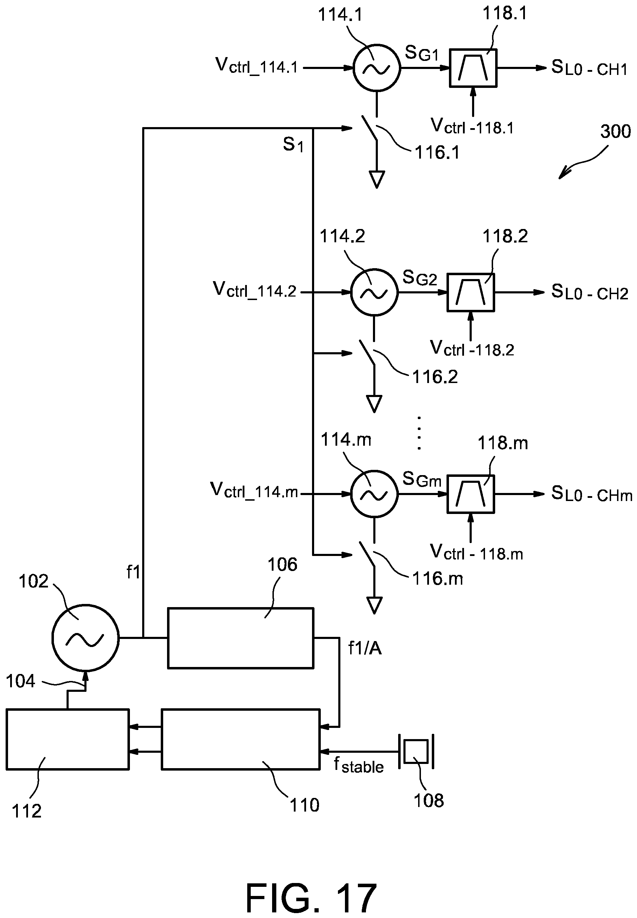

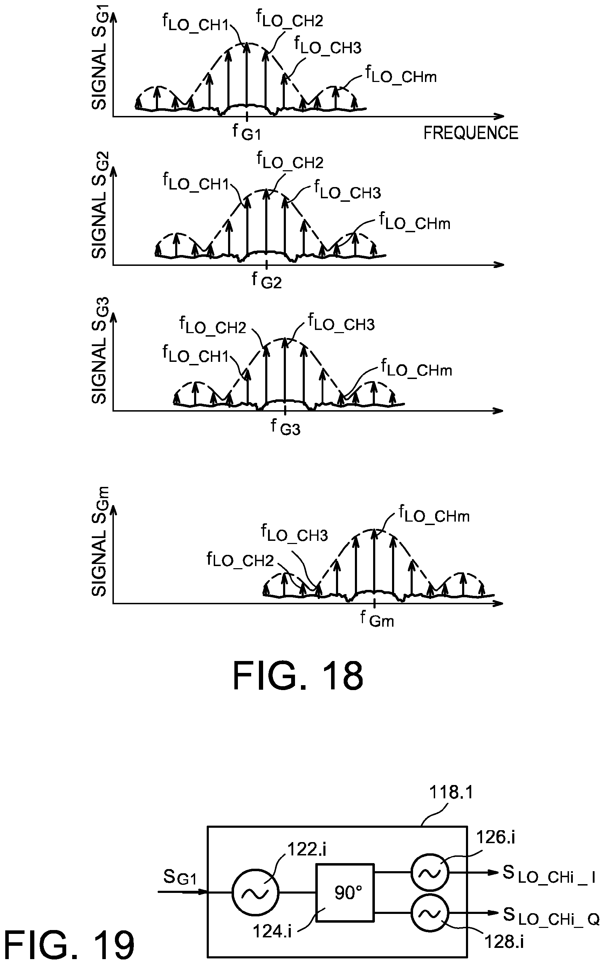

La figure 17 représente un dispositif de synthèse de fréquences 300 selon un troisième mode de réalisation. Comme le dispositif 100 précédemment décrit, le dispositif 300 comporte les éléments 102, 106, 108, 110 et 112 permettant de générer le signal périodique $S_1$. Par contre, le dispositif 300 comporte plusieurs générateurs de TORP comprenant chacun un oscillateur 114.1 à 114.m de type VCO, chacun contrôlé en tension par un signal de contrôle $V_{ctrl\_114.1}$ à $V_{ctrl\_114.m}$ propre, et des moyens d'alimentation électrique commandés 116.1 à 116.m chacun associé à l'un des oscillateurs 114.1 à 114.m et par exemple de nature similaire aux moyens 116 précédemment décrits. Ainsi, m signaux pulsés $S_{G1}$ à $S_{Gm}$ sont générés, les tensions de contrôle $V_{ctrl\_114.1}$ à $V_{ctrl\_114.m}$ étant telles que les fréquences centrales des signaux pulsés $S_{G1}$ à $S_{Gm}$ soient différentes les unes des autres et correspondent aux fréquences $f_{LO\_CH1}$ à $f_{LO\_CHm}$ destinées à être récupérées via les circuits de récupération de fréquence 118.1 à 118.m. La figure 18 représente des exemples de spectres des signaux $S_{G1}$ à $S_{Gm}$ obtenus.

Ce troisième mode de réalisation permet donc d'obtenir des signaux stables $S_{LO\_CH1}$ à $S_{LO\_CHm}$ dont les fréquences $f_{LO\_CH1}$ à $f_{LO\_CHm}$ sont des multiples de $f_1$, qui sont synchronisés en phase (du fait que les moyens de commande 116.1 à 116.m soient commandés par le même signal $S_1$) et qui sont de même amplitude du fait que les fréquences $f_{LO\_CH1}$ à $f_{LO\_CHm}$ correspondent aux fréquences centrales des signaux pulsés $S_{G1}$ à $S_{Gm}$. Comme précédemment, les fréquences $f_{LO\_CH1}$ à $f_{LO\_CHm}$ peuvent être des multiples entiers consécutifs ou non de $f_1$, cela étant choisi

via le choix des tensions de commande $V_{ctrl\_114.1}$ à $V_{ctrl\_114.m}$ et $V_{ctrl\_118.1}$ à $V_{ctrl\_118.m}$ (sur l'exemple de la figure 18, les fréquences $f_{LO\_CH1}$ à $f_{LO\_CHm}$ sont des multiples entiers consécutifs de $f_1$).

Les différentes variantes de réalisation décrites pour les dispositifs 100 et 200 peuvent s'appliquer pour ce dispositif 300 (chaque circuit récupérateur de fréquence 118.1 - 118.m pouvant comporter un ou plusieurs ILO et/ou un ou plusieurs filtres passe-bande., commandes des oscillateurs 114.1 - 114.m par des moyens de commande 116.1 - 116.m ou utilisation d'interrupteurs 202 commandés par le signal $S_1$, etc.).

Dans une autre variante de réalisation des dispositifs de synthèse de fréquences 100, 200 et 300, il est possible que ces dispositifs fournissent, en sortie de chacun des circuits récupérateurs de fréquences 118.1 - 118.m, deux signaux $S_{LO\_CHi\_I}$ et $S_{LO\_CHi\_Q}$ de même fréquence et de même amplitude, mais qui présentent entre eux un déphasage de 90°, c'est-à-dire l'un en phase avec le signal $S_1$ et l'autre en quadrature de phase par rapport à $S_1$ (signaux I/Q). Une telle variante peut notamment être utilisée au sein d'une architecture multicanaux réalisant une conversion directe d'une bande de fréquences intermédiaires à la bande de base.

La figure 19 représente un exemple de réalisation d'un circuit récupérateur de fréquence 118.i permettant de délivrer en sortie de tels signaux. Le circuit 118.i reçoit en entrée le signal pulsé $S_{Gi}$ de type TORP. Le circuit 118.i comporte un premier ILO 122.i dont l'entrée reçoit le signal $S_{Gi}$ et dont la sortie est reliée à l'entrée d'un élément déphaseur 124.i de type actif ou passif permettant de reproduire sur l'une de ses deux sorties le signal appliqué en entrée et de générer sur l'autre de ses deux sorties le signal appliqué en entrée déphasé de 90°. Chacun de ces deux signaux sont appliqués en entrées de deux autres ILO 126.i et 128.i délivrant en sortie les signaux $S_{LO\_CHU\_I}$ et $S_{LO\_CHi\_Q}$. Les deux ILO 126.i et 128.i fonctionnent soit de manière indépendante l'un de l'autre, soit de manière couplée telle que les sorties des deux ILO 126.i et 128.i soient déphasées l'une de l'autre de 90° sans faire appel à l'élément déphaseur 124.i. Le fonctionnement d'un tel élément de type Quadrature VCO (QVCO) est par exemple décrit dans le document « A 17.5-to-20.94GHz and 35-to-41.88GHz PLL in 65nm CMOS for wireless HD applications » de O. Richard et al., Solid-States Circuits Conférence Digest of Technical Papers (ISSCC), 2010 IEEE International, pages 252-253, 7-11 Feb. 2010.

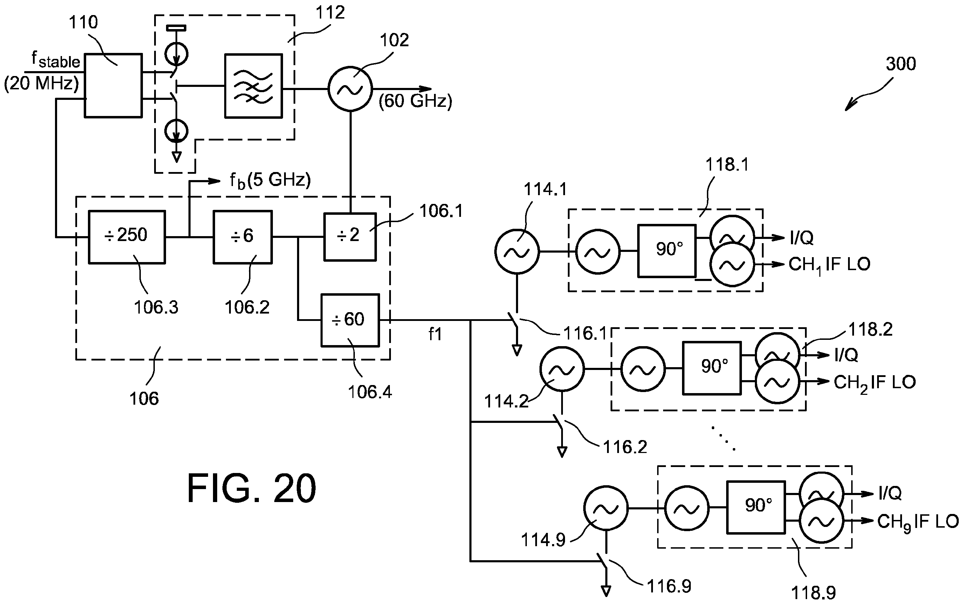

On décrit en liaison avec la figure 20 un exemple de réalisation du dispositif de synthèse de fréquences 300 comportant des circuits récupérateurs de fréquence correspondant au circuit 118.i précédemment décrit en liaison avec la figure 19.

Ce dispositif de synthèse de fréquences est destiné à être utilisé dans un système de transmission RF fonctionnant dans la gamme des fréquences E-band et utilisant neuf canaux, chacun de largeur de bande égale à 500 MHz et de fréquences centrales allant de 16,5 GHz à 20,5 GHz. Le signal de référence utilisé comporte une fréquence $f_{stable}$ égale à 20 MHz envoyé en entrée du comparateur de phases 110. Les signaux de sortie du comparateur de phases 110 sont envoyés en entrée du circuit de pompe de charge et du filtre 112 (ici passe-haut) délivrant en sortie le signal appliqué sur l'entrée de commande de l'oscillateur 102 qui est un VCO délivrant un signal de fréquence égale à 60 GHz (ce signal étant en outre utilisé dans les premiers étages de conversion haute et basse du système de transmission RF, c'est-à-dire servant de base pour la génération des signaux de fréquence $f_{LO\_IF1}$ et $f_{LO\_IF2}$ pour le système 1000 précédemment décrit en liaison avec la figure 4). Ce signal est envoyé à l'entrée des diviseurs de fréquence 106 formés d'un premier diviseur de fréquence 106.1 réalisant une division de fréquence par 2 et relié en série à un deuxième diviseur de fréquence 106.2 réalisant une division de fréquence par 6 lui-même relié en série à un troisième diviseur de fréquence 106.3 réalisant une division de fréquence par 250. Le signal obtenu en sortie du premier diviseur de fréquence 106.1 est également envoyé en entrée d'un quatrième diviseur de fréquence 106.4 réalisant une division de fréquence par 60 et délivrant le signal $S_1$ de fréquence $f_1$ égale à 500 MHz servant à contrôler les moyens 116.1 à 116.9 commandant l'alimentation des oscillateurs 114.1 à 114.9. Les signaux $S_{LO\_CH1}$ à $S_{LO\_CH9}$ (avec un signal en phase et un signal en quadrature pour chacun des neuf canaux) sont obtenus en sortie des circuits récupérateurs de fréquence 118.1 - 118.9, les fréquences $f_{LO\_CH1}$ à $f_{LO\_CH9}$ de ces signaux allant de 16,5 GHz à 20,5 GHz et étant espacées de 500 MHz les unes des autres.

Les dispositifs de synthèse de fréquences précédemment décrits peuvent également être utilisés dans un dispositif émetteur - récepteur de type électro-optique apte à envoyer des données via un multiplexage en longueurs d'ondes (WDM), c'est-à-dire en modulant plusieurs longueurs d'ondes envoyées via un même guide d'onde optique. Une autre manière d'exploiter une grande largeur de bande optique consiste à appliquer une modulation large bande à une seule longueur d'onde optique.

L'OFDM correspond à ce type de modulation dans laquelle plusieurs sous-porteuses électriques ayant des fréquences régulièrement espacées les unes des autres sont modulées individuellement par différents signaux en bande de base puis combinés et transposés autour de la fréquence optique. Un dispositif de synthèse de fréquence tel que décrit précédemment peut donc être utilisé au sein d'un tel dispositif émetteur - récepteur électro-optique de type OFDM pour fournir les sous-porteuses de fréquences différentes. Chacune de ces fréquences est dans ce cas modulée avec un flux de données différent puis transposée en fréquence dans le domaine optique en utilisant un modulateur ou un laser afin de fournir un signal optique OFDM.

**Revendications**

1. Dispositif de synthèse de fréquences (100, 200, 300), comportant au moins :

   - des premiers moyens (102, 104, 106, 108, 110, 112) aptes à générer un signal périodique de fréquence $f_1$,
   - des deuxièmes et troisièmes moyens (114, 116, 202), couplés aux premiers moyens (102, 104, 106, 108, 110, 112) et aptes à recevoir en entrée le signal périodique de fréquence $f_1$ et à générer au moins un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
   - des quatrièmes moyens (118) aptes à générer, à partir du signal $S_G$, m signaux périodiques $S_{LO\_CH1}$ à $S_{LO\_CHm}$ dont les spectres fréquentiels comportent chacun une raie principale de fréquence $f_{LO\_CHi}$ correspondant à un multiple entier de $f_1$, avec $1 \leq i \leq m$, i et m étant des nombres entiers, les quatrièmes moyens (118) jouant un rôle de filtre passe-bande appliqué sur le signal $S_G$ et rejetant des spectres fréquentiels de chacun des signaux périodiques $S_{LO\_CH1}$ à $S_{LO\_CHm}$ les raies autres que la raie principale de fréquence $f_{LO\_CHi}$.

2. Dispositif de synthèse de fréquences (100, 200, 300) selon la revendication 1, dans lequel les signaux périodiques $S_{LO\_CH1}$ à $S_{LO\_CHm}$ sont des signaux sensiblement sinusoïdaux présentant chacun une enveloppe sensiblement constante.

3. Dispositif de synthèse de fréquences (100, 200) selon l'une des revendications précédentes, dans lequel les deuxièmes moyens comportent au moins un oscillateur (114) commandé en tension dont une plage d'oscillation libre inclut la fréquence $N.f_1$, la valeur de N étant fonction d'une valeur d'une première tension de commande destinée à être appliquée en entrée de l'oscillateur (114) commandé en tension, et dans lequel les troisièmes moyens comportent au moins un interrupteur (116) relié à une entrée d'alimentation électrique de l'oscillateur (114) et apte à être commandé par le signal périodique de fréquence $f_1$ tel qu'il génère une tension d'alimentation de l'oscillateur (114) non nulle seulement pendant une partie de chaque période $T_1$ ou au moins un interrupteur (202) relié à une sortie de l'oscillateur (114) et apte à être commandé par le signal périodique de fréquence $f_1$ tel qu'il coupe une liaison électrique entre la sortie de l'oscillateur (114) et l'entrée des quatrièmes moyens (118) pendant une partie de chaque période $T_1$.

4. Dispositif de synthèse de fréquences (100, 200, 300) selon l'une des revendications précédentes, dans lequel les fréquences $f_{LO\_CHi}$ sont égales à des fréquences $(N+i-1).f_1$.

5. Dispositif de synthèse de fréquences (300) selon l'une des revendications 1 ou 2, dans lequel les deuxièmes moyens comportent m oscillateurs (114.1 - 114.m) commandés en tension aptes à générer m signaux $S_{G1}$ à $S_{Gm}$ correspondant chacun à un train d'oscillations de fréquence sensiblement égale à $N_i.f_1$, de durée inférieure à $T_1 = 1/f_1$ et répété périodiquement à la fréquence $f_1$, avec $N_i$ nombres entiers supérieurs à 1, dont des plages d'oscillation libre incluent les fréquences $N_i.f_1$, les valeurs de $N_i$ étant fonction de valeurs de premières tensions de commande destinées à être appliquées en entrées des oscillateurs (114.1 - 114.m) commandés en tension, et comportant en outre un ou plusieurs interrupteurs (116.1 - 116.m) chacun relié à une entrée d'alimentation électrique d'un des oscillateurs (114.1 - 114.m) et apte à être commandé par le signal périodique de fréquence $f_1$ tel qu'il génère une tension d'alimentation d'un des oscillateurs (114.1 - 114.m) non nulle seulement pendant une partie de chaque période $T_1$ et/ou un ou plusieurs interrupteurs (202) chacun relié à une sortie d'un des oscillateurs (114.1 - 114.m) et apte à être commandé par le signal périodique de fréquence $f_1$ tel qu'il coupe une liaison électrique entre la sortie d'un des oscillateurs (114.1 - 114.m) et l'entrée des quatrièmes moyens (118) pendant une partie de chaque période $T_1$, les interrupteurs (116.1 - 116.m, 202) formant les troisièmes moyens, et les quatrièmes moyens (118) étant aptes à générer les m signaux périodiques $S_{LO\_CH1}$ à $S_{LO\_CHm}$ à partir des signaux $S_{G1}$ à $S_{Gm}$.

6. Dispositif de synthèse de fréquences (300) selon la revendication 5, dans lequel les fréquences $f_{LO\_CHi}$ sont égales aux fréquences $N_i.f_1$ et/ou dans lequel les fréquences $N_i.f_1$ sont des multiples entiers consécutifs de la fréquence $f_1$.

7. Dispositif de synthèse de fréquences (100, 200, 300) selon l'une des revendications précédentes, dans lequel les quatrièmes moyens comportent plusieurs circuits récupérateurs de fréquence (118.1 - 118.m) délivrant chacun en sortie un des m signaux périodiques $S_{LO\_CH1}$ à $S_{LO\_CHm}$, chaque circuit récupérateur de fréquence (118.1 - 118.m) comportant au moins un oscillateur verrouillé par injection (122.i) destiné à recevoir en entrée le signal $S_G$ ou l'un des signaux $S_{G1}$ à $S_{Gm}$ et à être verrouillé au moins périodiquement à la fréquence $f_{LO\_CHi}$ dont la valeur est fonction d'une valeur d'une deuxième tension de commande destinée à être appliquée en entrée de l'oscillateur verrouillé par injection (122.i) et/ou chaque circuit récupérateur de fréquence (118.1 - 118.m) comportant au moins un filtre passe-bande de fréquence centrale sensiblement égale à $f_{LO\_CHi}$.

8. Dispositif de synthèse de fréquences (300) selon la revendication 7, dans lequel chaque circuit récupérateur de fréquence (118.1 - 118.m) comporte au moins deux oscillateurs verrouillés par injection (126.i, 128.i) dont l'un (126.i) est apte à délivrer en sortie l'un des m signaux périodiques $S_{LO\_CH1}$ à $S_{LO\_CHm}$ et l'autre (128.i) est apte à délivrer en sortie un autre signal périodique en quadrature de phase avec ledit un des m signaux périodiques $S_{LO\_CH1}$ à $S_{LO\_CHm}$ via un couplage réalisé entre les deux oscillateurs verrouillés par injection (126.i, 128.i) ou via un élément déphaseur (124.i) disposé entre les deuxièmes moyens (114) et les oscillateurs verrouillés par injection (126.i, 128.i).

9. Dispositif de synthèse de fréquences (100, 200, 300) selon l'une des revendications précédentes, dans lequel la valeur de la fréquence $f_1$ est supérieure à environ 500 MHz, et/ou les valeurs des fréquences $f_{LO\_CHi}$ sont supérieures à environ 10 GHz, et/ou les oscillations du signal $S_G$ ou des signaux $S_{G1}$ à $S_{Gm}$ sont sinusoïdales.

10. Dispositif de synthèse de fréquences (100, 200, 300) selon l'une des revendications précédentes, dans lequel les premiers moyens comportent au moins un dispositif résonateur (108) et une boucle à verrouillage de phase (102, 104, 106, 110, 112) apte à asservir la phase du signal périodique de fréquence $f_1$ délivré par un oscillateur commandé en tension (102) de la boucle à verrouillage de phase sur une phase d'un signal périodique délivré par le dispositif résonateur (108).

11. Dispositif de synthèse de fréquences (100, 200, 300) selon l'une des revendications 1 à 9, dans lequel les premiers moyens comportent un dispositif résonateur apte à générer le signal périodique de fréquence $f_1$.

12. Dispositif d'émission et/ou de réception de signaux (1000), comportant au moins un dispositif de synthèse de fréquences (100, 200, 300) selon l'une des revendications précédentes dont des sorties sur lesquelles sont délivrés les signaux périodiques $S_{LO\_CH1}$ à $S_{LO\_CHm}$ sont reliées à des entrées de mélangeurs (1016.1 - 1016.m, 1026.1 - 1026.m) du dispositif d'émission et/ou de réception (1000) aptes à réaliser une transposition de fréquences des signaux destinés à être émis et/ou reçus.

13. Procédé de synthèse de fréquences, comportant au moins les étapes de :

    - génération d'un signal périodique de fréquence $f_1$,
    - génération, à partir du signal périodique de fréquence $f_1$, d'au moins un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
    - génération, à partir du signal $S_G$, de m signaux périodiques $S_{LO\_CH1}$ à $S_{LO\_CHm}$ dont les spectres fréquentiels comportent chacun une raie principale de fréquence $f_{LO\_CHi}$ correspondant à un multiple entier de $f_1$, avec $1 \leq i \leq m$, i et m étant des nombres entiers, via la mise en oeuvre d'une fonction de filtrage passe-bande appliquée sur le signal $S_G$ et rejetant des spectres fréquentiels de chacun des signaux périodiques $S_{LO\_CH1}$ à $S_{LO\_CHm}$ les raies autres que la raie principale de fréquence $f_{LO\_CHi}$.

14. Procédé de réalisation d'un dispositif de synthèse de fréquences (100, 200, 300), comportant au moins les étapes de :

    - réalisation de premiers moyens (102, 104, 106, 108, 110, 112) aptes à générer un signal périodique de fréquence $f_1$,
    - réalisation de deuxièmes et troisièmes moyens (114, 116, 202), couplés aux premiers moyens (102, 104, 106, 108, 110, 112) et aptes à recevoir en entrée le signal périodique de fréquence $f_1$ et à générer au moins un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
    - réalisation de quatrièmes moyens (118) aptes à générer, à partir du signal $S_G$, m signaux périodiques $S_{LO\_CH1}$ à $S_{LO\_CHm}$ dont les spectres fréquentiels comportent chacun une raie principale de fréquence $f_{LO\_CHi}$ correspondant à un multiple entier de $f_1$, avec $1 \leq i \leq m$, i et m étant des nombres entiers, en jouant un rôle de filtre passe-bande appliqué sur le signal $S_G$ et rejetant des spectres fréquentiels de chacun des signaux périodiques $S_{LO\_CH1}$ à $S_{LO\_CHm}$ les raies autres que la raie principale de fréquence $f_{LO\_CHi}$.

**Patentansprüche**

1. Frequenzsynthesevorrichtung (100, 200, 300), die zumindest enthält:

- erste Mittel (102, 104, 106, 108, 110, 112), die dazu geeignet sind, ein periodisches Signal der Frequenz $f_1$ zu erzeugen,

- zweite und dritte Mittel (114, 116, 202), die mit den ersten Mitteln (102, 104, 106, 108, 110, 112) gekoppelt und dazu geeignet sind, am Eingang das periodische Signal der Frequenz $f_1$ zu empfangen und zumindest ein Signal $S_G$ zu erzeugen, das einem Schwingungszug der Frequenz im Wesentlichen gleich $N.f_1$ mit einer Dauer unter $T_1 = 1/f_1$ entspricht und periodisch wiederholt wird mit der Frequenz $f_1$, wobei N eine ganze Zahl größer als 1 ist,

- vierte Mittel (118), die dazu geeignet sind, ausgehend von dem Signal $S_G$ m periodische Signale $S_{LO-CH1}$ bis $S_{LO\_CHm}$ zu erzeugen, deren Frequenzspektren jeweils eine Frequenzhauptlinie $f_{LO\_CHi}$ enthalten, die einem ganzen Vielfachen von $f_1$ entspricht, mit $1 \leq i \leq m$, wobei i und m ganze Zahlen sind, wobei die vierten Mittel (118) die Rolle eines Bandpaßfilters spielen, das auf das Signal $S_G$ angewendet wird, und aus den Frequenzspektren eines jeden der periodischen Signale $S_{LO-CH1}$ bis $S_{LO\_CHm}$ andere Linien als die Frequenzhauptlinie $f_{LO\_CHi}$ abweisen.

2. Frequenzsynthesevorrichtung (100, 200, 300) nach Anspruch 1, wobei die periodischen Signale $S_{LO-CH1}$ bis $S_{LO\_CHm}$ im Wesentlichen sinusförmige Signale sind, die jeweils eine im Wesentlichen konstante Umhüllende aufweisen.

3. Frequenzsynthesevorrichtung (100, 200) nach einem der vorangehenden Ansprüche, wobei die zweiten Mittel zumindest einen spannungsgesteuerten Oszillator (114) enthalten, von dem ein freier Oszillationsbereich die Frequenz $N.f_1$ einschließt, wobei der Wert von N Funktion von einem Wert einer ersten Steuerspannung ist, die an den Eingang des spannungsgesteuerten Oszillators (114) angelegt werden soll, und wobei die dritten Mittel zumindest einen Schalter (116) enthalten, der mit einem elektrischen Versorgungseingang des Oszillators (114) verbunden und dazu geeignet ist, über das periodische Signal der Frequenz $f_1$ gesteuert zu werden, so dass er eine Versorgungsspannung ungleich null für den Oszillator (114) nur während eines Teils einer jeden Periode $T_1$ erzeugt, oder zumindest einen Schalter (202), der mit einem Ausgang des Oszillators (114) verbunden und dazu geeignet ist, über das periodische Signal der Frequenz $f_1$ gesteuert zu werden, so dass er eine elektrische Verbindung zwischen dem Ausgang des Oszillators (114) und dem Eingang der vierten Mittel (118) während eines Teils einer jeden Periode $T_1$ trennt.

4. Frequenzsynthesevorrichtung (100, 200, 300) nach einem der vorangehenden Ansprüche, wobei die Frequenzen $f_{LO\_CHi}$ gleich Frequenzen $(N+i-1).f_1$ sind.

5. Frequenzsynthesevorrichtung (300) nach einem der Ansprüche 1 oder 2, wobei die zweiten Mittel m spannungsgesteuerte Oszillatoren (114.1 - 114.m) enthalten, die dazu geeignet sind, m Signale $S_{G1}$ bis $S_{Gm}$ zu erzeugen, die jeweils einem Schwingungszug der Frequenz im Wesentlichen gleich $N_i.f_1$ mit einer Dauer unter $T_1 = 1/f_1$ entsprechen und periodisch wiederholt werden mit der Frequenz $f_1$, mit $N_i$ ganzen Zahlen größer als 1, von denen freie Oszillationsbereiche die Frequenzen $N_i.f_1$ einschließen, wobei die Werte von $N_i$ Funktion von Werten erster Steuerspannungen sind, die an den Eingängen der spannungsgesteuerten Oszillatoren (114.1 - 114.m) angelegt werden sollen, und ferner einen oder mehrere Schalter (116.1 - 116.m) enthalten, die jeweils mit einem elektrischen Versorgungseingang eines der Oszillatoren (114.1 - 114.m) verbunden und dazu geeignet sind, über das periodische Signal der Frequenz $f_1$ gesteuert zu werden, so dass er eine Versorgungsspannung ungleich null für einen der Oszillatoren (114.1 - 114.m) nur während eines Teils einer jeden Periode $T_1$ erzeugt, und/oder einen oder mehrere Schalter (202), die jeweils mit einem Ausgang eines der Oszillatoren (114.1 - 114.m) verbunden und dazu geeignet sind, über das periodische Signal der Frequenz $f_1$ gesteuert zu werden, so dass er eine elektrische Verbindung zwischen dem Ausgang eines der Oszillatoren (114.1 - 114.m) und dem Eingang der vierten Mittel (118) während eines Teils einer jeden Periode $T_1$ trennt, wobei die Schalter (116.1 - 116.m, 202) dritte Mittel bilden, und die vierten Mittel (118) dazu geeignet sind, die m periodischen Signale $S_{LO-CH1}$ bis $S_{LO\_CHm}$ ausgehend von den Signalen $S_{G1}$ bis $S_{Gm}$ zu erzeugen.

6. Frequenzsynthesevorrichtung (300) nach Anspruch 5, wobei die Frequenzen $f_{LO\_CHi}$ gleich den Frequenzen $N_i.f_1$ sind und/oder die Frequenzen $N_i.f_1$ aufeinanderfolgende, ganze Vielfache von der Frequenz $f_1$ sind.

7. Frequenzsynthesevorrichtung (100, 200, 300) nach einem der vorangehenden Ansprüche, wobei die vierten Mittel mehrere Frequenzwiederherstellungsschaltkreise (118.1 - 118.m) enthalten, die jeweils am Ausgang eines der m periodischen Signale $S_{LO\_CH1}$ bis $S_{LO\_CHm}$ ausgeben, wobei jeder Frequenzwiederherstellungsschaltkreis (118.1 - 118.m) zumindest einen injektionssynchronisierten Oszillator (122.i) enthält, der dazu bestimmt ist, am Eingang das Signal $S_G$ oder eines der Signale $S_{G1}$ bis $S_{Gm}$ zu empfangen und zumindest periodisch mit der Frequenz $f_{LO\_CHi}$ synchronisiert zu werden, deren Wert Funktion von einem Wert einer zweiten Steuerspannung ist, die an den Eingang des injektionssynchronisierten Oszillators (122.i) angelegt werden soll, und/oder jeder Frequenzwiederherstellungsschaltkreis (118.1 - 118.m) zumindest ein Bandpassfilter mit der Mittenfrequenz im Wesentlichen gleich $f_{LO\_CHi}$ enthält.

8. Frequenzsynthesevorrichtung (300) nach Anspruch 7, wobei jeder Frequenzwiederherstellungsschaltkreis (118.1 - 118.m) zumindest zwei injektionssynchronisierte Oszillatoren (126.i, 128.i) enthält, von denen der eine (126.i) dazu geeignet ist, am Ausgang eines der m periodischen Signale $S_{LO\_CH1}$ bis $S_{LO\_CHm}$ auszugeben und der andere (128.i) dazu geeignet ist, am Ausgang ein weiteres periodisches Signal in Phasenquadratur mit einem der m periodischen Signale $S_{LO\_CH1}$ bis $S_{LO\_CHm}$ über eine Kopplung auszugeben, die zwischen zwei injektionssynchronisierten Oszillatoren (126.i, 128.i) gebildet ist, oder über ein Phasenschieberelement (124.i), das zwischen den zweiten Mitteln (114) und den injektionssynchronisierten Oszillatoren (126.i, 128.i) angeordnet ist.

9. Frequenzsynthesevorrichtung (100, 200, 300) nach einem der vorangehenden Ansprüche, wobei der Wert der Frequenz $f_1$ höher als etwa 500 MHz ist und/oder die Werte der Frequenzen $f_{LO\_CHi}$ höher als etwa 10 GHz sind und/oder die Schwingungen des Signals SG oder der Signale $S_{G1}$ bis $S_{Gm}$ sinusförmig sind.

10. Frequenzsynthesevorrichtung (100, 200, 300) nach einem der vorangehenden Ansprüche, wobei die ersten Mittel zumindest eine Resonatoreinrichtung (108) und eine Phasenregelschleife (102, 104, 106, 110, 112) aufweisen, die dazu geeignet ist, die Phase des periodischen Signals der Frequenz $f_1$ zu regeln, das von einem spannungsgesteuerten Oszillator (102) der Phasenregelschleife auf einer Phase eines von der Resonatoreinrichtung (108) ausgegebenen periodischen Signals ausgegeben wird.

11. Frequenzsynthesevorrichtung (100, 200, 300) nach einem der Ansprüche 1 bis 9, wobei die ersten Mittel eine Resonatoreinrichtung aufweisen, die dazu geeignet ist, das periodische Signal der Frequenz $f_1$ zu erzeugen.

12. Vorrichtung zum Senden und/oder Empfangen von Signalen (1000), enthaltend zumindest eine Frequenzsynthesevorrichtung (100, 200, 300) nach einem der vorangehenden Ansprüche, deren Ausgänge, an denen die periodischen Signale $S_{LO\_CH1}$ bis $S_{LO\_CHm}$ ausgegeben werden, mit Eingängen von Mischern (1016.1 - 1016.m, 1026.1 - 1026.m) der Sende- und/oder Empfangsvorrichtung (1000) verbunden sind, die dazu geeignet sind, eine Frequenzumsetzung der Signale durchzuführen, die gesendet und/oder empfangen werden sollen.

13. Frequenzsyntheseverfahren, umfassend zumindest die nachfolgenden Schritte:

   - Erzeugen eines periodisches Signals der Frequenz $f_1$,
   - Erzeugen zumindest eines Signals $S_G$ ausgehend von dem periodischen Signal der Frequenz $f_1$, das einem Schwingungszug der Frequenz im Wesentlichen gleich $N.f_1$ mit einer Dauer unter $T_1 = 1/f_1$ entspricht und periodisch wiederholt wird mit der Frequenz $f_1$, wobei N eine ganze Zahl größer als 1 ist,
   - Erzeugen von m periodischen Signalen $S_{LO-CH1}$ bis $S_{LO\_CHm}$ ausgehend von dem Signal $S_G$, deren Frequenzspektren jeweils eine Frequenzhauptlinie $f_{LO\_CHi}$ enthalten, die einem ganzen Vielfachen von $f_1$ entspricht, mit $1 \le i \le m$, wobei i und m ganze Zahlen sind, durch Ausführen einer Bandpaßfilterfunktion, die auf das Signal $S_G$ angewendet wird und aus den Frequenzspektren eines jeden der periodischen Signale $S_{LO-CH1}$ bis $S_{LO\_CHm}$ andere Linien als die Frequenzhauptlinie $f_{LO\_CHi}$ abweist.

14. Verfahren zum Herstellen einer Frequenzsynthesevorrichtung (100, 200, 300), umfassend zumindest die nachfolgenden Schritte:

   - Herstellen von ersten Mitteln (102, 104, 106, 108, 110, 112), die dazu geeignet sind, ein periodisches Signal der Frequenz $f_1$ zu erzeugen,
   - Herstellen von zweiten und dritten Mitteln (114, 116, 202), die mit den ersten Mitteln (102, 104, 106, 108, 110, 112) gekoppelt und dazu geeignet sind, am Eingang das periodische Signal der Frequenz $f_1$ zu empfangen und zumindest ein Signal $S_G$ zu erzeugen, das einem Schwingungszug der Frequenz im Wesentlichen gleich $N.f_1$ mit einer Dauer unter $T_1 = 1/f_1$ entspricht und periodisch wiederholt wird mit der Frequenz $f_1$, wobei N eine ganze Zahl größer als 1 ist,
   - Herstellen von vierten Mitteln (118), die dazu geeignet sind, ausgehend von dem Signal $S_G$ m periodische Signale $S_{LO-CH1}$ bis $S_{LO\_CHm}$ zu erzeugen, deren Frequenzspektren jeweils eine Frequenzhauptlinie $f_{LO\_CHi}$ enthalten, die einem ganzen Vielfachen von $f_1$ entspricht, mit $1 \le i \le m$, wobei i und m ganze Zahlen sind, indem sie die Rolle eines Bandpaßfilters spielen, das auf das Signal $S_G$ angewendet wird und aus den Frequenzspektren eines jeden der periodischen Signale $S_{LO-CH1}$ bis $S_{LO\_CHm}$ andere Linien als die Frequenzhauptlinie $f_{LO\_CHi}$ abweist.

**Claims**

1. A frequency synthesis device (100, 200, 300), including at least:

   - first means (102, 104, 106, 108, 110, 112) able to generate a periodical signal with a frequency $f_1$,
   - second and third means (114,116, 202), coupled to the first means (102, 104, 106, 108, 110, 112) and able to receive at the input the periodical signal with a frequency $f_1$ and to generate at least one signal $S_G$ corresponding to a train of oscillations with a frequency substantially equal to $N.f_1$, with a duration lower than $T_1 = 1/f_1$ and periodically repeated at the frequency $f_1$, with N an integer number higher than 1,
   - fourth means (118) able to generate, from the signal $S_G$, m periodical signals $S_{LO\_CH1}$ to $S_{LO\_CHm}$ the frequency spectra of which each include a main line with a frequency $f_{LO\_CHi}$ corresponding to an integer multiple of $f_1$, with $1 \leq i \leq m$, i and m being integer numbers, the fourth means (118) playing the role of a band-pass filter applied to the signal $S_G$ and discarding from the frequency spectra of each of the periodical signals $S_{LO\_CH1}$ to $S_{LO\_CHm}$ lines other than the main line with a frequency $f_{LO\_CHi}$.

2. The frequency synthesis device (100, 200, 300) according to claim 1, wherein the periodical signals $S_{LO\_CH1}$ to $S_{LO\_CHm}$ are substantially sinusoidal signals each having a substantially constant envelope.

3. The frequency synthesis device (100, 200) according to one of the preceding claims, wherein the second means include at least one voltage-controlled oscillator (114) a free oscillation range of which includes the frequency $N.f_1$, the value of N being a function of a value of a first control voltage for being applied at the input of the voltage-controlled oscillator (114), and wherein the third means include at least one switch (116) connected to a power supply input of the oscillator (114) and able to be controlled by the periodical signal with a frequency $f_1$ such that it generates a non-null supply voltage to the oscillator (114) only during part of each period $T_1$ or at least one switch (202) connected to an output of the oscillator (114) and able to be controlled by the periodical signal with a frequency $f_1$ such that it breaks an electrical connection between the output of the oscillator (114) and the input of the fourth means (118) during part of each period $T_1$.

4. The frequency synthesis device (100, 200, 300) according to one of the preceding claims, wherein the frequencies $f_{LO\_CHi}$ are equal to frequencies $(N+i-1).f_1$.

5. The frequency synthesis device (300) according to one of claims 1 or 2, wherein the second means include m voltage-controlled oscillators (114.1 - 114.m) able to generate m signals $S_{G1}$ to $S_{Gm}$ each corresponding to a train of oscillations with a frequency substantially equal to $N_i.f_1$, with a duration lower than $T_1 = 1/f_1$ and periodically repeated at the frequency $f_1$, with $N_i$ integer numbers higher than 1, the free oscillation ranges of which include the frequencies $N_i.f_1$, the values of $N_i$ being a function of the values of the first control voltages for being applied at the inputs of the voltage-controlled oscillators (114.1-114.m) and further including one or more switches (116.1-116.m) each connected to a power supply input of one of the oscillators (114.1 - 114.m) and able to be controlled by the periodical signal with a frequency $f_1$ such that it generates a non-null supply voltage of one of the oscillators (114.1 - 114.m) only during part of each period $T_1$ and/or one or more switches (202) each connected to an output of one of the oscillators (114.1 - 114.m) and able to be controlled by the periodical signal with a frequency $f_1$ such that it breaks an electrical connection between the output of one of the oscillators (114.1 - 114.m) and the input of the fourth means (118) during part of each period $T_1$, the switches (116.1 - 116.m, 202) forming the third means, and the fourth means (118) being able to generate the m periodical signals $S_{LO\_CH1}$ to $S_{LO\_CHm}$ from the signals $S_{G1}$ to $S_{Gm}$.

6. The frequency synthesis device (300) according to claim 5, wherein the frequencies $f_{LO\_CHi}$ are equal to the frequencies $N_i.f_1$ and/or wherein the frequencies $N_i.f_1$ are consecutive integer multiples of the frequency $f_1$.

7. The frequency synthesis device (100, 200) according to one of the preceding claims, wherein the fourth means include several frequency recovering circuits (118.1 - 118.m) each outputting one of the m periodical signals $S_{LO\_CH1}$ to $S_{LO\_CHm}$, each frequency recovering circuit (118.1 - 118.m) including at least one injection-locked oscillator (122.i) for receiving at the input the signal $S_G$ or one of the signals $S_{G1}$ to $S_{Gm}$ and being at least periodically locked at the frequency $f_{LO\_CHi}$ the value of which is a function of the value of a second control voltage for being applied at the input of the injection-locked oscillator (122.i) and/or each frequency recovering circuit (118.1-118.m) including at least one band-pass filter with a centre frequency substantially equal to $f_{LO\_CHi}$.

8. The frequency synthesis device (300) according to claim 7, wherein each frequency recovering circuit (118.1 - 118.m) includes at least two injection-locked oscillators (126.i, 128.i) one (126.i) of which is able to output one of the m periodical signals $S_{LO\_CH1}$ to $S_{LO\_CHm}$ and the other (128.i) of which is able to output another periodical signal in phase quadrature with said one of the m periodical signals $S_{LO\_CH1}$ to $S_{LO\_CHm}$ via a coupling made between both injection-locked oscillators (126.i, 128.i) or via a phase shifter element (124.i) arranged between the second means (114) and the injection-locked oscillators (126.i, 128.i).

9. The frequency synthesis device (100, 200, 300) according to one of the preceding claims, wherein the value of the frequency $f_1$ is higher than about 500 MHz, and/or the values of the frequencies $f_{LO\_CHi}$ are higher than about 10 GHz, and/or the oscillations of the signal $S_G$ or of the signals $S_{G1}$ to $S_{Gm}$ are sinusoidal.

10. The frequency synthesis device (100, 200, 300) according to one of the preceding claims, wherein the first means include at least one resonator device (108) and a phase-locked loop (102, 104, 106, 110, 112) able to regulate the phase of the periodical signal with a frequency $f_1$ outputted by the voltage-controlled oscillator (102) of the phase-locked loop to a phase of a periodical signal outputted by the resonator device (108).

11. The frequency synthesis device (100, 200, 300) according to one of claims 1 to 9, wherein the first means include a resonator device able to generate the periodical signal with a frequency $f_1$.

12. A device for transmitting and/or receiving signals (1000), including at least one frequency synthesis device (100, 200, 300) according to one of the preceding claims whose outputs on which are outputted the periodical signals $S_{LO\_CH1}$ to $S_{LO\_CHm}$ are connected to inputs of mixers (1016.1 - 1016.m, 1026.1 - 1026.m) of the transmitting and/or receiving device (1000) able to carry out a frequency translation of the signals to be transmitted and/or received.

13. A frequency synthesis method, including at least the steps of:

- generating a periodical signal with a frequency $f_1$,
- generating, from the periodical signal with a frequency $f_1$, at least one signal $S_G$ corresponding to a train of oscillations with a frequency substantially equal to $N.f_1$, with a duration lower than $T_1 = 1/f_1$ and periodically repeated at the frequency $f_1$, with N an integer number higher than 1,
- generating, from the signal $S_G$, m periodical signals $S_{LO\_CH1}$ to $S_{LO\_CHm}$ the frequency spectra of which each include a main line with a frequency $f_{LO\_CHi}$ corresponding to an integer multiple of $f_1$, with $1 \le i \le m$, i and m being integer numbers, via implementing a band-pass filtering function applied to the signal $S_G$ and discarding from the frequency spectra of each of the periodical signals $S_{LO\_CH1}$ to $S_{LO\_CHm}$ lines other than the main line with a frequency $f_{LO\_CHi}$.

14. A method for making a frequency synthesis device (100, 200, 300), including at least the steps of:

- making first means (102, 104, 106, 108, 110, 112) able to generate a periodical signal with a frequency $f_1$,
- making second and third means (114, 116, 202), coupled to the first means (102, 104, 106, 108, 110, 112) and able to receive at the input the periodical signal with a frequency $f_1$ and to generate at least one signal $S_G$ corresponding to a train of oscillations with a frequency substantially equal to $N.f_1$, with a duration lower than $T_1 = 1/f_1$ and periodically repeated at the frequency $f_1$, with N an integer number higher than 1,
- making fourth means (118) able to generate, from the signal $S_G$, m periodical signals $S_{LO\_CH1}$ to $S_{LO\_CHm}$ the frequency spectra of which each include a main line with a frequency $f_{LO\_CHi}$ corresponding to an integer multiple of $f_1$, with $1 \le i \le m$, i and m being integer numbers, by playing the role of a band-pass filter applied to the signal $S_G$ and discarding from the frequency spectra of each of the periodical signals $S_{LO\_CH1}$ to $S_{LO\_CHm}$ lines other than the main line with a frequency $f_{LO\_CHi}$.

f1

12

14

10

f1/N

16

fquartz

20

18

# FIG. 1

30

f1=N.fquartz

fquartz

16

32

# FIG. 2

FIG. 3

FIG. 5

FIG. 4

EP 3 005 567 B1

FIG. 6

FIG. 7A

FIG. 8A

FIG.7B

FIG. 8B

$$T_{L0-CHi} = 1/f_{L0-CHi}$$

SIGNAL $S_{L0-CHi}$

TEMPS

## FIG. 9A

SIGNAL $S_{L0-CHi}$

$f_{L0-CHi}$   FREQUENCE

## FIG. 9B

120

$f_{L0 - CH1} = Nf_1$

FREQUENCE

## FIG. 10

SIGNAL $S_G$(dBm)

-10
-15
-20
-25
-30
-35
-40
-45
-50
-55
-60
-65
-70

54    56    58    60    62    64    66    68    70

FREQUENCE(GHz)

## FIG. 14

FIG. 11A

FIG. 11B

FIG. 12A

FIG. 12B

FIG. 13

FIG. 15

FIG. 16

FIG. 17

FIG. 18

FIG. 19

FIG. 20

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100142598 A1

- WO 2008069444 A1

**Littérature non-brevet citée dans la description**

- **V. DYADYUK et al.** A Multigigabit Millimeter-Wave Communication System With Improved Spectral Efficiency. *Microwave Theory and Techniques, IEEE Transactions on,* Décembre 2007, vol. 55 (12), 2813-2821
- **A. SILIGARIS et al.** A 60 GHz UWB impulse radio transmitter with integrated antenna in CMOS65nm SOI technology. *Silicon Monolithic Integrated Circuits in RF Systems (SiRF), 2011 IEEE 11th Topical Meeting on,* 17 Janvier 2011, 153-156
- **O. RICHARD et al.** A 17.5-to-20.94GHz and 35-to-41.88GHz PLL in 65nm CMOS for wireless HD applications. *Solid-State Circuits Conférence Digest of Technical Papers (ISSCC), 2010 IEEE International-al,* 07 Février 2010, 252-253

- **M. TIEBOUT.** A 50 GHz direct injection locked oscillator topology as low power frequency divider in 0.13 μm CMOS. *Solid-State Circuits Conference, 2003. ESSCIRC '03. Proceedings of the 29th European,* 16 Septembre 2003, 73-76
- **O. RICHARD et al.** A 17.5-to-20.94GHz and 35-to-41.88GHz PLL in 65nm CMOS for wireless HD applications. *Solid-States Circuits Conférence Digest of Technical Papers (ISSCC), 2010 IEEE International-al,* 07 Février 2010, 252-253